# EUROPEAN PATENT SPECIFICATION

(11) **EP 2 186 637 B1**
(45) Date of publication and mention of the grant of the patent: **02.05.2012**
(21) Application number: 08167404.6
(22) Date of filing: 23.10.2008
(51) Int. Cl.: B41C 1/10, G03F 7/029

(54) **A lithographic printing plate**
Lithographiedruckplatte
Plaque d'impression lithographique

(43) Date of publication of application: 19.05.2010
(73) Proprietor: Agfa Graphics N.V., 2640 Mortsel (BE)
(72) Inventor: Williamson, Alexander, 2640 Mortsel (BE); Loccufier, Johan, 2640 Mortsel (BE); Wynants, Sonny, 2640 Mortsel (BE); Heylen, Kristof, 2640 Mortsel (BE)

(56) References cited:
- EP-A2- 0 360 151
- EP-A2- 0 720 053
- EP-A2- 1 447 238
- EP-A2- 1 630 608
- EP-A2- 1 642 745
- JP-A- 63 077 903
- US-A1- 2003 215 744
- US-A1- 2007 202 438
- ANONYMOUS: "Hammett Sigma Constants*" WIRED CHEMIST DATA TABLES, [Online] XP002513639 Retrieved from the Internet: URL:http://www.wiredchemist.com/chemistry/ data/hammett_sigma_constants.html>

## Description

### FIELD OF THE INVENTION

The present invention relates to a lithographic printing plate precursor which comprises a photopolymerisable composition and to a method for making a lithographic printing plate whereby this precursor is image-wise exposed and developed with a gum solution or on-press with a fountain solution and ink.

### BACKGROUND OF THE INVENTION

In lithographic printing, a so-called printing master such as a printing plate is mounted on a cylinder of the printing press. The master carries a lithographic image on its surface and a printed copy is obtained by applying ink to said image and then transferring the ink from the master onto a receiver material, which is typically paper. In conventional, so-called "wet" lithographic printing, ink as well as an aqueous fountain solution (also called dampening liquid) are supplied to the lithographic image which consists of oleophilic (or hydrophobic, i.e. ink-accepting, water-repelling) areas as well as hydrophilic (or oleophobic, i.e. water-accepting, ink-repelling) areas. In so-called "driographic" printing, the lithographic image consists of ink-accepting and ink-abhesive (ink-repelling) areas and during driographic printing, only ink is supplied to the master.

Printing masters are generally obtained by the so-called computer-to-film (CtF) method, wherein various pre-press steps such as typeface selection, scanning, color separation, screening, trapping, layout and imposition are accomplished digitally and each color selection is transferred to graphic arts film using an imagesetter. After processing, the film can be used as a mask for the exposure of an imaging material called plate precursor and after plate processing, a printing plate is obtained which can be used as a master. Since about 1995, the so-called 'computer-to-plate' (CtP) method has gained a lot of interest. This method, also called 'direct-to-plate', bypasses the creation of film because the digital document is transferred directly to a printing plate precursor by means of a so-called platesetter. A printing plate precursor for CtP is often called a digital plate.

Digital plates can roughly be divided in three categories : (i) silver plates, which work according to the silver salt diffusion transfer mechanism; (ii) photopolymer plates which contain a photopolymerizable composition that hardens upon exposure to light and (iii) thermal plates of which the imaging mechanism is triggered by heat or by light-to-heat conversion. Thermal plates are mainly sensitized for infrared lasers emitting at 830 nm or 1064 nm. Photopolymers can be sensitized for blue, green or red light (i.e. wavelength range between 450 and 750 nm), for violet light (i.e. wavelength range between 350 and 450 nm) or for infrared light(i.e. wavelength range between 750 and 1500 nm). Laser sources have been increasingly used to expose a printing plate precursor which is sensitized to a corresponding laser wavelength. Typically, an Ar laser (488 nm) or a FD-YAG laser (532 nm) can be used for exposing a visible light sensitized photopolymer plate. The wide-scale availability of low cost blue or violet laser diodes, originally developed for data storage by means of DVD, has enabled the production of platesetters operating at shorter wavelength. More specifically, semiconductor lasers emitting from 350 to 450 nm have been realized using an InGaN material. An infrared laser diode emitting around 830 nm or a Nd-YAG laser emitting around 1060 nm can also be used.

Typically, a photopolymer plate is processed in alkaline developer having a pH > 10. Currently, most commercial lithographic plates require an additional gumming process after the exposed plates is developed and before it is put on the press, in order to protect the plate from contamination, e.g. by oxidation, fingerprints, fats, oil or dust, or from damaging, e.g. by scratches during handling of the plate. Such an additional gumming step is not convenient for the end-user, because it is a time consuming step and requires an additional gumming station.

WO 02/101 469 discloses a method of processing an imageable element useful as alkaline-developable lithographic printing plate precursor wherein the element is developed and gummed with an aqueous alkaline developing-gumming solution comprising a water-soluble polyhydroxy compound having a specific structure.

EP 1 342 568 discloses a method for making a heat-sensitive lithographic printing plate wherein the image-wise heated precursor, comprising a coating of hydrophobic thermoplastic polymer particles which coalescence on heating, is developed with a gum solution. A practical embodiment for this type of printing plates was introduced by Agfa under the tradename Azura.

In US 6,027,857, US 6,171,735, US 6,420,089, US 6,071,675, US 6,245,481, US 6,387,595, US 6,482,571, US 6,576,401, WO 93/05446, WO 03/087939, US 2003/16577, EP 1 557 262, US 2004/13968 and US 2006/0046196 a method is disclosed for preparing a lithographic printing plate wherein a photopolymer plate, after image-wise exposure, is mounted on a press and processed on-press by applying ink and fountain solution to remove the unexposed areas from the support.

The photopolymerisble layer may further comprise compounds as disclosed in EP 851 299, EP 1 091 251, US 2004/214105, EP 1 491 356, US 2005/39620, EP 1 495 866, EP 1 500 498 and EP 1 520 694.

EP 1 882 585 discloses a lithographic printing plate precursor comprising an aluminum support having a hydrophilic surface, and a photosensitive layer comprising a binder polymer having an acid value of 0.3 meq/g or less, wherein the photosensitive layer comprises a pigment dispersed with a pigment dispersant which is free from a -COOH group, a -PO₃H₂ group or a -OPO₃H₂ group.

EP 1 510 865 discloses an organic polyhalogen compound as photoinitiator in the photopolymerisable composition.

US 2007/0202438, EP-A 1 630 608, EP-A 360 151 and US 2003/0215744 disclose a lithographic printing plate comprising a a support and thereon a photopolymerisable layer containing a polymeric binder, a polymerisable ethylenically unsaturated compound and a photopolymerisation initiator, said initiator being a titanocene compound, an iron-arene complex, a monoalkyltriaryl borate compound or a trihaloalkyl compound. The trihaloalkyl group is preferably a trihalomethyl group which is bonded directly or through a conjugated chain to an aromatic hydrocarbon or heterocyclic ring.

EP-A 1 447 238 discloses a printing plate material comprising a support and provided thereon, an image formation layer, said image formation layer containing heat melting particles or heat fusible particles and further a combination of a photo-induced acid generating agent and a compound varying its color by an acid. The photo-induced acid generating agent can be a polyhalogenated compound such as trichloromethyl phenyl sulfone.

In WO 2005/111727, WO 2007/057333, WO 2007/057334, WO 2007/057335, WO 2007/057336, WO 2007/057337, WO 2007/057346, 2007/057347, WO 2007/057348, WO 2007/057349 and WO 2007/057442 a method for making a lithographic printing plate wherein the image-wise exposed precursor, comprising a photopolymerisable coating, is developed with a gumming solution.

In this gum processing and in this on-press processing with fountain solution and ink as explained above, the image-wise exposed plate precursors are processed under non-aggressive conditions because no strongly alkaline (pH ≥ 12) solutions are used and, therefore, the removal of the coating in the non-exposed areas can be incomplete (i.e. insufficient clean-out) and this may result in an increased tendency of accepting ink in the hydrophilic non-image areas on the press (i.e. toning). The printing plate precursors of the prior art suffer from an increased tendency to toning after ageing. Under ageing is understood that the precursor is stored under critical conditions of light, temperature and relative humidity. The sensitivity of these plate precursors is also reduced after ageing. It is important for a high quality printing plate that the plate precursor exhibits a good shelf-life, i.e. no loss of sensitivity and no tendency of toning.

### SUMMARY OF THE INVENTION

It is an object of the present invention to provide a lithographic printing plate precursor which exhibits an excellent daylight stability and shelf-life. This object is realized by the lithographic printing plate precursor as defined in claim 1, having the specific feature that the photopolymerisable composition comprises (i) a polymerization initiator which is a trihalomethyl-aryl sulphone wherein the aryl group is substituted by at least one electron-donating group and wherein the sum of the Hammett constants (sigma) of the substituting groups on said aryl group has a negative value, and (ii) a pigment dispersed in a dispersant, wherein the dispersant is a compound free of -COOH, -PO₃H₂ or -OPO₃H₂ groups.

In another object of the present invention, a method for making a lithographic printing plate is provided wherein the printing plate precursor as defined in claim 1, is image-wise exposed and processed off-press with a gum solution or on-press with fountain and ink while printing, whereby the precursor exhibits an excellent daylight stability and shelf-life.

Other specific embodiments of the invention are defined in the dependent claims.

### DETAILED DESCRIPTION OF THE INVENTION

In accordance with the present invention, there is provided a lithographic printing plate precursor which comprises an aluminum support having a hydrophilic surface and a coating provided thereon, the coating comprises a photopolymerisable composition having a polymerisable compound, a pigment dispersed with a dispersant, a polymerization initiator and a binder, characterized in that the dispersant is a compound free of -COOH, -PO₃H₂ or -OPO₃H₂ groups and the polymerization initiator is a trihalomethyl-aryl sulphone, wherein the aryl group is substituted by at least one electron-donating group and wherein the sum of the Hammett constants (sigma) of the substituting groups on said aryl group has a negative value.

In another embodiment of the present invention, there is provided a method of making a lithographic printing plate comprising the steps of:
a) providing a lithographic printing plate precursor as defined above,
b) image-wise exposing said coating,
c) optionally, heating the precursor,
d) developing the precursor by treating the coating of the precursor with a gum solution thereby removing the coating from the support in the non-exposed areas, or by treating the coating of the precursor by mounting the exposed precursor on a plate cylinder of a lithographic printing press and rotating the plate cylinder while feeding dampening liquid and/or ink to the coating.

The printing plate precursor of the present invention exhibits an improved stability against daylight. This means that the printing plate precursors do not need to be protected from daylight exposure in the different steps upon preparing the plate. The daylight stability is defined and determined by the method as described in the examples. The coating may not be polymerised and/or crosslinked under influence of daylight irradiation to such an extent that it is not removable in the processing step, resulting in toning during printing. This can be tested by the method as described in the examples wherein the precursor is exposed to a white light source through a graduated density filter, placed on the precursor. The number of the steps remaining on the plate after processing needs to be as low as possible. In accordance with the present invention, the precursor is considered daylight stable when the number of steps in this test is less than 10.

The printing plate precursor of the present invention also exhibits an improved shelf-life. This means that the sensitivity and the clean-out level after ageing of the precursor do not decrease. The sensitivity is defined and determined by the method as described in the examples. In accordance with the present invention, the loss of sensitivity after ageing the precursor is less than 50 mJ/cm², preferably less than 45 mJ/cm², more preferably at most 40 mJ/cm². The clean-out performance is defined and determined by the method as described in the examples. The clean-out performance of the plate is evaluated by the appearance of toning on the printed sheets. In accordance with the present invention, the printing plates of the present invention exhibit no toning after ageing of the precursor.

As a result of intensive investigations to achieve the above-described object, the inventors have found that an improved daylight stability and shelf-life can be achieved by the specific combination of the pigment dispersed with the dispersant of the present invention and the polymerisation initiator of the present invention, present in the coating of the precursor. The inventors unexpectly found that, due to the presence of both the type of the polymerisation initiator as defined above and the type of the dispersant as defined above, the precuror exhibits an excellent stability under daylight exposure, no or little loss of sensitivity and no formation of toning after ageing.

### The support

A particularly preferred lithographic support is an electrochemically grained and anodized aluminum support. Graining an anodizing of aluminum supports is well known. The acid used for graining can be e.g. nitric acid or sulfuric acid. The acid used for graining preferably comprises hydrogen chloride. Also mixtures of e.g. hydrogen chloride and acetic acid can be used. The relation between electrochemical graining and anodizing parameters such as electrode voltage, nature and concentration of the acid electrolyte or power consumption on the one hand and the obtained lithographic quality in terms of the surface roughness Ra and anodic weight (g/m² of Al₂O₃ formed on the aluminum surface) on the other hand is well known. More details about the relation between various production parameters and Ra or anodic weight can be found in e.g. the article "Management of Change in the Aluminium Printing Industry" by F. R. Mayers, published in the ATB Metallurgie Journal, volume 42 nr. 1-2 (2002) pag. 69.

In the EP-A 1 826 021 a characterizing method of the surface of a grained and anodized aluminum is disclosed. The parameter mean pith depth', calculated according to this characterizing method, correlates with the number and depth of the pits present at the aluminum surface. The mean pith depth of the aluminum surface is preferably less then 2.0 µm, more preferably less then 1.8 µm, most preferably less then 1.5 µm. The standard deviation of the 'mean pith depth' is preferably less then 0.70 µm, more preferably less then 0.50 µm, most preferably less then 0.35 µm.

The anodized aluminum support may be subject to a so-called post-anodic treatment to improve the hydrophilic properties of its surface. For example, the aluminum support may be silicated by treating its surface with a sodium silicate solution. Alternatively, a phosphate treatment may be applied which involves treating the aluminum oxide surface with a phosphate solution that may further contain an inorganic fluoride. Further, the aluminum oxide surface may be rinsed with a citric acid or citrate solution. This treatment may be carried out at room temperature or may be carried out at a slightly elevated temperature of about 30 to 50°C. A further interesting treatment involves rinsing the aluminum oxide surface with a bicarbonate solution. Still further, the aluminum oxide surface may be treated with polyvinylphosphonic acid, polyvinylmethylphosphonic acid, phosphoric acid esters of polyvinyl alcohol, polyvinylsulfonic acid, polyvinylbenzenesulfonic acid, sulfuric acid esters of polyvinyl alcohol, and acetals of polyvinyl alcohols formed by reaction with a sulfonated aliphatic aldehyde.

Another useful post-anodic treatment may be carried out with a solution of polyacrylic acid or a polymer comprising at least 30 mol% of acrylic acid monomeric units, e.g. GLASCOL E15, a polyacrylic acid, commercially available from ALLIED COLLOIDS.

In a preferred embodiment of the present invention, the grained and anodised aluminum support is not subjected to a so-called post-anodic treatment as defined above.

The grained and anodized aluminum support may be a sheet-like material such as a plate or it may be a cylindrical element such as a sleeve which can be slid around a print cylinder of a printing press.

The support can also be a metal support such as aluminum or stainless steel. The metal can also be laminated to a plastic layer, e.g. polyester film. Alternative supports for the plate precursor can also be used, such as amorphous metallic alloys (metallic glasses). Such amorphous metallic alloys can be used as such or joined with other non-amorphous metals such as aluminum. Examples of amorphous metallic alloys are described in US5,288,344, US5,368,659, US5,618,359, US5,735,975, US5,250,124, US5,032,196, US6,325,868, and US6,818,078, the disclosures of which are incorporated by reference. The following references describe the science of amorphous metals in much more detail and are incorporated as references: Introduction to the Theory of Amorphous Metals, N.P. Kovalenko et al.(2001); Atomic Ordering in Liquid and Amorphous Metals, S.I. Popel, et al; Physics of Amorphous Metals, N.P. Kovalenko et al (2001). The metal surface can be grained and anodized as described above.

The support can also be a flexible support, which may be provided with a hydrophilic layer, hereinafter called 'base layer'. The flexible support is e.g. paper, plastic film or aluminum. Preferred examples of plastic film are polyethylene terephthalate film, polyethylene naphthalate film, cellulose acetate film, polystyrene film, polycarbonate film, etc. The plastic film support may be opaque or transparent.

The base layer is preferably a cross-linked hydrophilic layer obtained from a hydrophilic binder cross-linked with a hardening agent such as formaldehyde, glyoxal, polyisocyanate or a hydrolyzed tetra-alkylorthosilicate. The latter is particularly preferred. The thickness of the hydrophilic base layer may vary in the range of 0.2 to 25 µm and is preferably 1 to 10 µm. More details of preferred embodiments of the base layer can be found in e.g. EP-A 1 025 992.

### The coating

The coating comprises a photopolymerisable composition having a polymerisable compound, a pigment dispersed with a dispersant as defined below, a polymerization initiator as defined below and a binder. The coating may be composed of one or more layers wherein at least one of these layers comprises a polymerisable composition.

The coating may further comprise an adhesion promoting compound, present in the polymerisable composition of the coating and/or in an intermediate layer between the hydrophilic surface of the support and the coating.

The precursor may further comprise an oxygen-barrier layer on top of the coating. The oxygen-barrier layer comprises a water-soluble or water-swellable polymer, this oxygen-barrier layer hereinafter also referred to as "toplayer" or "overcoat layer" or "overcoat".

### The adhesion promoting compound

The adhesion promoting compound is a non-polymeric compound which contains a group having an ethylenically unsaturated bond and a group selected from a phosphate group, a phosphonate group and a trialkoxysilane group. These groups selected from a phosphate group, a phosphonate group and a trialkoxysilane group are preferably capable of interacting with the support. Said compound is not a polymeric compound, this means that, when said functional group capable of interacting with the support is part of a recurring monomeric unit, not more than 4 of said monomeric units are present in the compound. In a preferred embodiment, the compound comprises not more than 3 of said monomeric units, more preferably not more than 2 of said monomeric units, most preferably the compound comprises only one of said monomeric unit.

Under "interacting" is understood each type of physical and/or chemical reaction or process whereby, between the functional group and the support, a bond is formed which can be a covalent bond, an ionic bond, a complex bond, a coordinate bond or a hydrogen-bridge bond, and which can be formed by an adsorption process, a chemical reaction, an acid-base reaction, a complex-forming reaction or a reaction of a chelating group or a ligand.

Examples of adhesion promoting compounds suitable for the present invention are disclosed in EP-A 851 299 from lines 22 on page 3 to line 1 on page 4, EP-A 1 500 498 from paragraph [0023] on page 7 to paragraph [0052] on page 20, EP-A 1 495 866 paragraph [0030] on page 5 to paragraph [0049] on page 11, EP-A 1 091 251 from paragraph [0014] on page 3 to paragraph [0018] on page 20, and EP-A 1 520 694 from paragraph [0023] on page 6 to paragraph [0060] on page 19.

Preferred functional groups are a phosphate group or a phosphonate group, more preferred is a phosphate group.

Preferred adhesion promoting compounds are selected from at least one of the following monomers:
vinyl phosphonic acid, 4-vinylbenzyl phosphonic acid,
(oligo)ethyleneoxy(meth)acrylate phosphate such as Sipomer PAM100 and ethyleneglycol methacrylate phosphate,
oligo)ethyleneoxy(meth)acrylate phosphonate, trialkoxysilane alkyl (meth)acrylate, and salts thereof, and each of these monomers being optionally substituted.

In another preferred embodiment, said functional group is capable of interacting with a grained and anodized aluminium support, optionally provided with a post-anodic treatment. Highly preferred adhesion promoting compounds are those compounds which comprise a phosphate or phosphonate group as functional group capable of adsorbing on the grained and anodized aluminium support, optionally provided with a postanodic treatment, and which comprise an addition-polymerizable ethylenic double bond reactive group. Such compounds are preferably selected from those compounds described in EP-A 851 299 from lines 22 on page 3 to line 1 on page 4 and EP-A 1 500 498 from paragraph [0023] on page 7 to paragraph [0052] on page 20.

### Polymerization initiator

The polymerization initiator is a compound capable of generating free radicals, optionally in the presence of a sensitizer, upon exposure. The polymerization initiator is hereinafter also referred to as "free radical initiator". The polymerization initiator is capable of hardening the polymerisable compound in the exposed areas of the coating.

In accordance with the present invention, the polymerization initiator is a trihalomethyl-aryl sulphone wherein the aryl group is substituted by at least one electron-donating group and wherein the sum of the Hammett constants (sigma) of the substituting groups on the aryl group has a negative value, preferably a value of -0.10 or less, more preferably a value of -0.15 or less. (Information about the Hammett constants can be found in handbooks and basic literature, e.g. "A Survey of Hammett Substituent Constants and Resonance and Field Parameters" from C. Hansch, A. Leo and R.W. Taft, Chem. Reviews, 1991, 91, 165-195.)

The halo groups are preferably a chloro, bromo or iodo group or a mixture of these groups, more preferably a chloro or bromo group or a mixture of these two groups, most preferably a bromo group.

The aryl group is preferably a 5- or 6- membered aromatic group, more preferably a 6-membered aromatic group. A 6-membered aromatic group is preferably a carbocyclic aromatic group, more preferably a phenyl group or a naphthyl group, most preferably a phenyl group. The 6-membered aromatic group is substituted by an electron-donating group on the ortho, para or meta position, preferably on the ortho or para position, more preferably on the para position. The 6-membered aromatic group is substituted by at least one electron-donating group, optionally by two or more electron-donating group or by at least one electron-donating group and one or more other group(s), with the proviso that the sum of the Hammett constants (sigma) has a negative value, preferably a value of -0.10 or less, more preferably a value of -0.15 or less. The 6-membered aromatic group is preferably substituted by one electron-donating group, more preferably by one electron-donating group in the para or ortho position, most preferably by one electron-donating group in the para position.

The electron-donating group is preferably selected from a hydroxyl group, an alkoxy group, an alkyl group, an amino group, a mono-alkyl amino group, a mono-aryl amino group, a di-alkyl amino group, a di-aryl amino group, a tri-alkyl silane group, -NH(CO)R or -NH(CO)NHR wherein R is an alkyl or aryl group, or -O⁻M⁺ wherein M⁺ is an alkali metal ion, an ammonium ion or a tetra-alkyl ammonium ion, more preferably a hydroxyl group, an alkoxy group or an alkyl group, most preferably a hydroxyl group.

In a highly preferred embodiment, the polymerization initiator is a trihalomethyl-phenyl sulphone wherein the phenyl is substituted by at least one electron-donating group and wherein the sum of the Hammett constants (sigma) of the substituting groups on the phenyl group has a negative value, preferably a value of -0.10 or less, more preferably a value of -0.15 or less. The phenyl group is substituted by an electron-donating group on the ortho, para or meta position, preferably on the ortho or para position, more preferably on the para position. The phenyl group is substituted by at least one electron-donating group, optionally by two or more electron-donating group or by at least one electron-donating group and one or more other group(s), with the proviso that the sum of the Hammett constants (sigma) has a negative value, preferably a value of -0.10 or less, more preferably a value of -0.15 or less. The phenyl group is preferably substituted by one electron-donating group, more preferably by one electron-donating group in the para or ortho position, most preferably by one electron-donating group in the para position. The electron-donating group substituted on the phenyl group is preferably selected from the list as mentioned above, more preferably from a hydroxyl group, an alkoxy group or an alkyl group, most preferably a hydroxyl group.

Examples of polymerization initiators according to the present invention are listed below (the sum of the Hammett constants (sigma), hereinafter also referred to as Σ(σ), is indicated for each initiator; when the value for the substituents is not exactly known or is not available in the literature, the Hammett constant of the most chemically similar group, where a Hammett constant is available in the literature, is used; the Hammett constant for an ortho substituent is assumed to be the same as for a para substituent):
PI-01 is 4-hydroxyphenyl-tribromomethyl-sulfone, hereinafter also referred to as p-OH-TBMPS; Σ(σ) = - 0.37;
PI-02 is 2-hydroxyphenyl-tribromomethyl-sulfone, hereinafter also referred to as o-OH-TBMPS; Σ(σ) = - 0.37;
PI-03 is 4-methoxyphenyl-tribromomethyl-sulfone, hereinafter also referred to as p-OMe-TBMPS; Σ(σ) = - 0.27;
PI-04 is 2-methoxyphenyl-tribromomethyl-sulfone, hereinafter also referred to as o-OMe-TBMPS; Σ(σ) = - 0.27;
PI-05 is 2,4-dimethoxyphenyl-tribromomethyl-sulfone, hereinafter also referred to as o,p-di-OMe-TBMPS; Σ(σ) = - 0.54;
PI-06 is 4-tolyl-tribromomethyl-sulfone, hereinafter also referred to as p-Me-TBMPS; Σ(σ) = - 0.17;
PI-07 is tribromomethyl-[4-(2-hydroxyethoxy)phenyl]sulfone, hereinafter also referred to as p-O-Et-OH-TBMPS; Σ(σ)= - 0.24; and PI-08 is 4-(tribromomethanesulfonyl)-phenoxy-acetic acid, hereinafter also referred to as p-O-Me-COOH-TBMPS; Σ(σ) = - 0.27.

In addition to the polymerisation initiator of the present invention, other free radical initiators capable of generating free radicals directly or in the presence of a sensitizer upon exposure can be used in this invention.

### The polymerizable compound

The polymerizable monomer or oligomer may be a ethylenically unsaturated compound, having at least one terminal ethylenic group, hereinafter also referred to as "free-radical polymerizable monomer".

In accordance with the present invention, this polymerizable monomer or oligomer is different from the non-polymeric compound which contains a group having an ethylenic unsaturated bond and a group selected from a phosphate, a phosphonate and a trialkoxysilane group.

Suitable free-radical polymerizable monomers may include, for example, multifunctional (meth)acrylate monomers (such as (meth)acrylate esters of ethylene glycol, trimethylolpropane, pentaerythritol, ethoxylated ethylene glycol and ethoxylated trimethylolpropane, multifunctional urethanated (meth)acrylate, and epoxylated (meth)acrylate), and oligomeric amine diacrylates. The (meth)acrylic monomers may also have other double bond or epoxide group, in addition to (meth)acrylate group. The (meth)acrylate monomers may also contain an acidic (such as carboxylic acid) or basic (such as amine) functionality.

Particular multifunctional monomers for use in the polymer coating are disclosed in US 6,410,205 , US 5,049,479 , EP 1 079 276, EP 1 369 232, EP 1 369 231, EP 1 341 040, US 2003/0124460 , EP 1 241 002, EP 1 288 720 and in the reference book including the cited references : Chemistry & Technology UV & EB formulation for coatings, inks & paints - Volume 2 -Prepolymers and Reactive Diluents for UV and EB Curable Formulations by N.S. Allen, M.A. Johnson, P.K.T. Oldring, M.S. Salim - Edited by P.K.T. Oldring - 1991 - ISBN 0 947798102. Particularly preferred are urethane (meth)acrylate multifunctional monomers, which can be used alone or in combination with other (meth)acrylate multifunctional monomers. The functionality of these monomers is preferably 2 to 6 (meth)acrylate groups per monomer molecule. Mixtures of multifunctional monomers with different functionality can be used to obtain improved plate characteristics.

The polymerizable coating may further comprise a polymerizable monomer or oligomer comprising at least one epoxy or vinyl ether functional group. The initiator for polymerizing this type of monomers or oligomers can be a Bronsted acid generator capable of generating free acid, optionally in the presence of a sensitizer, upon exposure, hereinafter said initiator also referred to as "cationic photoinitiator" or "cationic initiator". Suitable polyfunctional epoxy monomers include, for example, 3,4-epoxycyclohexylmethyl-3,4-epoxycyclohex-ane carboxylate, bis-(3,4 - epoxycyclohexymethyl) adipate, difunctional bisphenol Aepichlorohydrin epoxy resin and multifunctional epichlorohydrinitetraphenylol ethane epoxy resin. Suitable cationic photoinitiators include, for example, triarylsulfonium hexafluoroantimonate, triarylsulfonium hexafluorophosphate, diaryliodonium hexafluoroantimonate, and haloalkyl substituted s-triazine. It is noted that most cationic initiators are also free radical initiators because, in addition to generating Bronsted acid, they also generate free radicals during photo or thermal decomposition.

The polymerizable monomer or oligomer may also be a combination of a monomer or oligomer comprising at least one epoxy or vinyl ether functional group and a polymerizable ethylenically unsaturated compound, having at least one terminal ethylenic group, and the initiator may be a combination of a polymerization initiator according to the present invention and a cationic initiator as defined above. A monomer or oligomer comprising at least one epoxy or vinyl ether functional group and a polymerizable ethylenically unsaturated compound, having at least one terminal ethylenic group, can be the same compound wherein the compound contains both ethylenic group and epoxy or vinyl ether group. Examples of such compounds include epoxy functional acrylic monomers, such as glycidyl acrylate. The coating may also comprise a multifunctional monomer which contains at least two functional groups selected from an ethylenically unsaturated group and an epoxy or vinyl ether group.

The coating may also comprise a co-initiator. Typically, a co-initiator is used in combination with a free radical initiator or a cationic initiator. Particular co-initiators for use in the coating are disclosed in US 6,410,205, US 5,049,479, EP 1 079 276, EP 1 369 232, EP 1 369 231, EP 1 341 040, US 2003/0124460 , EP 1 241 002 , EP 1 288 720 and in the reference book including the cited references : Chemistry & Technology UV & EB formulation for coatings, inks & paints - Volume 3 -Photoinitiators for Free Radical and Cationic Polymerisation by K.K. Dietliker - Edited by P.K.T. Oldring - 1991 - ISBN 0 947798161.

The polymerizable coating may also comprise an inhibitor. Particular inhibitors for use in the photopolymer coating are disclosed in US 6,410,205, EP 1 288 720 and WO2005/109103.

### Binder of the coating

In accordance with the present invention, the binder of the coating of the precursor is a polymer or a mixture of polymers, selected from a wide series of organic polymers, with the proviso that, when the polymer comprises monomeric units having -COOH, -PO₃H₂ or -OPO₃H₂ groups, said polymer is present in the coating in an amount less than 0.1 g/m², preferably less than 0.05 g/m², more preferably less than 0.025 g/m². Said polymer or mixture of polymers preferably include at least one of the following polymers or polymers comprising at least one of the following monomeric units:
- chlorinated polyalkylene (in particular chlorinated polyethylene and chlorinated polypropylene),
- methacrylic acid alkyl esters or alkenyl esters (in particular methyl (meth)acrylate, ethyl (meth)acrylate, butyl (meth)acrylate, isobutyl (meth)acrylate, hexyl (meth)acrylate and (2-ethylhexyl)(meth)acrylate),
- hydroxy-alkyl (meth)acrylate such as hydroxyl-ethyl (meth)acrylate,
- (meth)acrylic acid alkyl esters or alkenyl esters with other copolymerizable monomers (in particular with (met)acrylonitrile, vinyl chloride, vinylidene chloride, styrene and/or butadiene),
- vinyl chloride, vinylchloride/(meth)acrylonitrile copolymers,
- vinylidene chloride, vinylidene chloride/(meth)acrylonitrile copolymers,
- monomeric units having a sulphonate group such as vinyl sulphonic acid or styrene sulphonic acid,
- vinyl acetate, vinyl alcohol, copolymers of vinyl acetate and/or vinyl alcohol, partially hydrolyzed polyvinyl acetate,
- vinyl pyrrolidone, copolymers of vinyl pyrrolidone or alkylated vinyl pyrrolidone,
- vinyl caprolactam, copolymers of vinyl caprolactam,
- ethylene oxide monomers, propylene oxide monomers, copolymers of ethylene oxide and/or propylene oxide,
- (meth)acrylonitrile, (meth)acrylonitrile/styrene copolymers,
- (meth)acrylamide, methylol (meth)acrylamide, (meth)acrylamide/ alkyl (meth)acrylate copolymers,
- styrene, α-methylstyrene, (meth)acrylonitrile/butadiene/styrene (ABS) terpolymers,
- polyamides,
- polyurethanes,
- polyesters,
- gum Arabic,
- derivates of cellulose such as methyl cellulose, ethyl cellulose, acetyl cellulose, hydroxy-(C₁-C₄-alkyl)cellulose and carboxymethyl cellulose,
- vinyl formal, and
- vinyl butyral.

Particulary preferred polymers are polyvinyl acetate, partially hydrolyzed polyvinyl acetate, polyethylene oxide, copolymers of ethylene oxide and/or propylene oxide, derivates of cellulose, gum Arabic, and copolymers containing at least one of the following monomeric units selected from vinyl acetate, vinyl alcohol, vinyl caprolactam, vinyl pyrrolidone, alkylated vinylpyrrolidone, alkyl (meth)acrylate, hydroxy-alkyl (meth)acrylate, (meth)acrylamide and monomeric units having a sulphonate group.

Particulary highly preferred polymers are partially hydrolyzed polyvinylacetate, preferably hydrolyzed for less than 60 mol%, more preferably hydrolyzed for at least 15 mol% and for less than 60 mol%, most preferably hydrolyzed for at least 20 mol% and for less than 58 mol%. The viscosity of the copolymers of vinylacetate and vinylalcohol are measured on a 4 weight % aqueous solution at 20°C as defined in DIN 53 015 and the viscosity ranges preferably between 3 and 60 mPa.s, more preferably between 4 and 30 mPa.s, most preferably between 5 and 25 mPa.s. The average molecular weight M_{w} of the copolymers of vinylacetate and vinylalcohol ranges preferably between 5 000 and 500 000 g/mol, more preferably between 10 000 and 400 000 g/mol, most preferably between 15 000 and 250 000 g/mol.

Alkylated vinylpyrrolidone polymers can be obtained by grafting alfa-olefins onto the vinylpyrrolidone polymer backbone. Typical examples of such products are the Agrimer AL Graft polymers commercially available from ISP. The length of the alkylation group may vary from C₄ to C₃₀.

Other useful binders are binders containing carboxyl groups, in particular copolymers containing monomeric units of α,β-unsaturated carboxylic acids or monomeric units of α,β-unsaturated dicarboxylic acids (preferably acrylic acid, methacrylic acid, crotonic acid, vinylacetic acid, maleic acid or itaconic acid).

By the term "copolymers" are to be understood in the context of the present invention as polymers containing units of at least 2 different monomers, thus also terpolymers and higher mixed polymers. Particular examples of useful copolymers are those containing units of (meth)acrylic acid and units of alkyl (meth)acrylates, allyl (meth)acrylates and/or (meth)acrylonitrile as well as copolymers containing units of crotonic acid and units of alkyl (meth)acrylates and/or (meth)acrylonitrile and vinylacetic acid/alkyl (meth)acrylate copolymers. Also suitable are copolymers containing units of maleic anhydride or maleic acid monoalkyl esters. Among these are, for example, copolymers containing units of maleic anhydride and styrene, unsaturated ethers or esters or unsaturated aliphatic hydrocarbons and the esterification products obtained from such copolymers. Further suitable binders are products obtainable from the conversion of hydroxyl-containing polymers with intramolecular dicarboxylic anhydrides. Further useful binders are polymers in which groups with acid hydrogen atoms are present, some or all of which are converted with activated isocyanates. Examples of these polymers are products obtained by conversion of hydroxyl-containing polymers with aliphatic or aromatic sulfonyl isocyanates or phosphinic acid isocyanates. Also suitable are polymers with aliphatic or aromatic hydroxyl groups, for example copolymers containing units of hydroxyalkyl (meth)acrylates, allyl alcohol, hydroxystyrene or vinyl alcohol, as well as epoxy resins, provided they carry a sufficient number of free OH groups. Particular useful binder and particular useful reactive binders are disclosed in EP 1 369 232, EP 1 369 231, EP 1 341 040, US 2003/0124460, EP 1 241 002, EP 1 288 720, US 6,027,857, US 6,171,735 and US 6,420,089.

The polymers used as binders have a typical mean molecular weight M_{W} between 1 200 and 700 000, preferably between 1 500 and 350 000. The amount of all the binder polymers together generally ranges from 10 to 90 % by weight, preferably 20 to 80 % by weight, relative to the total weight of the non-volatile components of the composition.

Other preferred binders are disclosed in EP 152 819 B1 on page 2 lines 50-page 4 line 20, and in EP 1 043 627 B1 on paragraph [0013] on page 3.

The polymeric binder may also comprise a hydrophobic backbone, and pendant groups including for example a hydrophilic poly(alkylene oxide) segment.

The polymeric binder may also include pendant cyano groups attached to the hydrophobic backbone. A combination of such binders may also be employed. Generally the polymeric binder is a solid at room temperature, and is typically a non-elastomeric thermoplastic. The polymeric binder comprises both hydrophilic and hydrophobic regions, which is thought to be important for enhancing differentiation of the exposed and unexposed areas by facilitating developability. Generally the polymeric binder is characterized by a number average molecular weight (Mn) in the range from about 10.000 to 250.000, more commonly in the range from about 25.000 to 200.000. The polymerizable composition may comprise discrete particles of the polymeric binder. Preferably the discrete particles are particles of the polymeric binder which are suspended in the polymerizable composition. The presence of discrete particles tends to promote developability of the unexposed areas. Specific examples of the polymeric binders according to this embodiment are described in US 6.899.994, 2004/0260050, US2005/0003285, US2005/0170286 and US2005/0123853. In addition to the polymeric binder of this embodiment the imageable layer may optionally comprise one or more co-binders. Typical co-binders are water-soluble or water-dispersible polymers, such as, cellulose derivatives, poly vinyl alcohol, poly acrylic acid, poly(meth)acrylic acid, poly vinyl pyrrolidone, polylactide, poly vinyl phosphonic acid, synthetic copolymers, such as the co-polymer of an alkoxy polyethylene glycol (meth)acrylate. Specific examples of co-binders are described in US2004/0260050, US2005/0003285 and US2005/0123853. Printing plate precursors, the imageable layer of which comprises a binder and optionally a co-binder according this embodiment and described in more detail in US2004/0260050, US2005/0003285 and US2005/0123853, optionally comprises a topcoat and an interlayer.

Another highly preferred suitable binder is a polymer which contains an acid group and a basic nitrogen-containing compound capable of neutralizing said acid group or a polymer which contains an acid group which is neutralised with a basic nitrogen-containing compound. Said basic nitrogen-containing compound has preferably an amino group, an amidine group or a guanidine group. Said amino group is preferably a tertiary amino group. In another preferred embodiment, said basic nitrogen-containing compound further comprises a group having an ethylenically unsaturated bond. Said group having an ethylenically unsaturated bond is most preferably a vinyl group or a (meth)acrylate group.

All these polymers or a mixture of all these polymers as mentioned above may be used with the proviso that, when the polymer comprises monomeric units having -COOH, -PO₃H₂ or -OPO₃H₂ groups, said polymer is present in the coating in an amount less than 0.1 g/m², preferably less than 0.05 g/m², more preferably less than 0.025 g/m².

### Pigment dispersed with a dispersant

In accordance with the present invention, the photopolymerisable composition further comprises a pigment dispersed with a dispersant wherein the dispersant is a compound which is free of -COOH, -PO₃H₂ or -OPO₃H₂ groups. This compound can be a low molecular weight compound having a molecular weight less than 1000 and being free of -COOH, -PO₃H₂ or -OPO₃H₂ groups, or a (co)polymer comprising monomeric units which do not contain a -COOH, -PO₃H₂ or - OPO₃H₂ group. The (co)polymer is preferred.

The coating of the precursor comprises the pigment dispersion of the present invention and, after processing, at least part of the pigment remains on the hardened coating areas, and a visible image is produced on the aluminum support by removing the coating, including the pigment, from the non-exposed areas in the processing. In order to obtain a complete clean-out of the non-hardened coating from the support and to avoid toning on the press, it is important that the pigment and the dispersant used for dispersing the pigment do not remain on the hydrophilic surface of the aluminum support after processing with a gum solution or on-press with fountain and ink. This can be obtained by using a dispersant for the pigment dispersion which does not adsorb on the surface of the aluminum support. Therefore, the dispersant does not contain a functional group which interacts with the surface of the aluminum support such as a -COOH, -PO₃H₂ or -OPO₃H₂ group.

This formation of a visible image can be advantageous when the precursor is off-press processed with a gum solution. The presence of the pigment in the printing areas of the plate can also be advantageous for improving the printing run length of the plate on the press.

Any type of pigment which is colored for the human eye, can be used in the pigment dispersion of the present invention, such as organic pigments, inorganic pigments, carbon black, metallic powder pigments and fluorescent pigments; organic pigments are preferred. Specific examples of organic pigments include quinacridone pigments, quinacridonequinone pigments, dioxazine pigments, phthalocyanine pigments, anthrapyrimidine pigments, anthanthrone pigments, indanthrone pigments, flavanthrone pigments, perylene pigments, diketopyrrolopyrrole pigments, perinone pigments, quinophthalone pigments, anthraquinone pigments, thioindigo pigments, benzimidazolone pigments, isoindolinone pigments, azomethine pigments, and azo pigments.

Specific examples of pigments which can be used in the pigment dispersion of the present invention are the following (herein is C.I. an abbreviation for Color Index; under a Blue colored pigment is understood a pigment that appears blue for the human eye; the other colored pigments have to be understood in an analogue way):
- Blue colored pigments which include C.I. Pigment Blue 1, C.I. Pigment Blue 2, C.I. Pigment Blue 3, C.I. Pigment Blue 15 : 3, C.I. Pigment Blue 15 : 4, C.I. Pigment Blue 15 : 34, C.I. Pigment Blue 16, C.I. Pigment Blue 22, C.I. Pigment Blue 60 and the like; and C.I. Vat Blue 4, C.I. Vat Blue 60 and the like;
- Red colored pigments which include C.I. Pigment Red 5, C.I. Pigment Red 7, C.I. Pigment Red 12, C.I. Pigment Red 48 (Ca), C.I. Pigment Red 48 (Mn), C.I. Pigment Red 57 (Ca), C.I. Pigment Red 57 : 1, C.I. Pigment Red 112, C.I. Pigment Red 122, C.I. Pigment Red 123, C.I. Pigment Red 168, C.I. Pigment Red 184, C.I. Pigment Red 202, and C.I. Pigment Red 209;
- Yellow colored pigments which include C.I. Pigment Yellow 1, C.I. Pigment Yellow 2, C.I. Pigment Yellow 3, C.I. Pigment Yellow 12, C.I. Pigment Yellow 13, C.I. Pigment Yellow 14C, C.I. Pigment Yellow 16, C.I. Pigment Yellow 17, C.I. Pigment Yellow 73, C.I. Pigment Yellow 74, C.I. Pigment Yellow 75, C.I. Pigment Yellow 83, C.I. Pigment Yellow 93, C.I. Pigment Yellow 95, C.I. Pigment Yellow 97, C.I. Pigment Yellow 98, C.I. Pigment Yellow 109, C.I. Pigment Yellow 110, C.I. Pigment Yellow 114, C.I. Pigment Yellow 128, C.I. Pigment Yellow 129, C.I. Pigment Yellow 138, C.I. Pigment Yellow 150, C.I. Pigment Yellow 151, C.I. Pigment Yellow 154, C.I. Pigment Yellow 155, C.I. Pigment Yellow 180, and C.I. Pigment Yellow 185;
- Orange colored pigments include C.I. Pigment Orange 36, C.I. Pigment Orange 43, and a mixture of these pigments. Green colored pigments include C.I. Pigment Green 7, C.I. Pigment Green 36, and a mixture of these pigments;
- Black colored pigments include: those manufactured by Mitsubishi Chemical Corporation, for example, No. 2300, No. 900, MCF 88, No. 33, No. 40, No. 45, No. 52, MA 7, MA 8, MA 100, and No. 2200 B; those manufactured by Columbian Carbon Co., Ltd., for example, Raven 5750, Raven 5250, Raven 5000, Raven 3500, Raven 1255, and Raven 700; those manufactured by Cabot Corporation, for example, Regal 400 R, Regal 330 R, Regal 660 R, Mogul L, Monarch 700, Monarch 800, Monarch 880, Monarch 900, Monarch 1000, Monarch 1100, Monarch 1300, and Monarch 1400; and those manufactured by Degussa, for example, Color Black FW 1, Color Black FW 2, Color Black FW 2 V, Color Black FW 18, Color Black FW 200, Color Black S 150, Color Black S 160, Color Black S 170, Printex 35, Printex U, Printex V, Printex 140 U, Special Black 6, Special Black 5, Special Black 4A, and Special Black 4.

Other types of pigments such as brown pigments, violet pigments, fluorescent pigments and metallic powder pigments can also be used. The pigments may be used alone or as a mixture of two or more pigments.

Blue colored pigments, including cyan pigments, are preferred.

The pigments in the pigment dispersion of the present invention can be subjected to surface treatment of the pigment particles. Methods for surface treatment include methods of applying a surface coat of resin, methods of applying a surfactant, and methods of bonding a reactive material to the surface of the pigment. The reactive material does not contain functional groups which interact with the surface of the aluminium support such as a -COOH, -PO₃H₂ or -OPO₃H₂ group. The reactive material can be selected from a silane coupling agent, an epoxy compound, polyisocyanate, or the like. Suitable examples of pigments with surface treatment can be found in the modified pigments as described in WO 02/04210. Specifically the blue colored modified pigments described in WO 02/04210 are preferred as colorant in the present invention.

The pigments have a particle size which is preferably less than 10 µm, more preferably less than 5 µm and especially preferably less than 3 µm. The method for dispersing the pigments may be any known dispersion method which is used for the production of ink or toner or the like. Dispersing machines include an ultrasonic disperser, a sand mill, an attritor, a pearl mill, a super mill, a ball mill, an impeller, a dispenser, a KD mill, a colloid mill, a dynatron, a three-roll mill and a press kneader. Details thereof are described in "Latest Pigment Applied Technology" (CMC Publications, published in 1986).

Suitable dispersants for each type of pigment, suitable amounts of dispersant to the pigment and suitable methods for preparing the dispersions can be found in EP 1 882 585 A1 on paragraph 58 to 87. A specific example of a dispersant of the present invention is Disperbyk 182 from BYK Chemie.

Typically, the amount of pigment in the coating may be in the range of about 0.005 g/m² to 2 g/m², preferably about 0.007 g/m² to 0.5 g/m², more preferably about 0.01 g/m² to 0.2 g/m², most preferably about 0.01 g/m² to 0.1 g/m².

### Dye

The coating of the precursor may further comprise a dye as an additional colorant. Any known dyes, such as commercially available dyes or dyes described in, for example, "Dye Handbook" (edited by the Organic Synthetic Chemistry Association, published in 1970) which are colored for the human eye, can be used as colorant in the photopolymerizable coating. Specific examples thereof include azo dyes, metal complex salt azo dyes, pyrazolone azo dyes, anthraquinone dyes, phthalacyanine dyes, carbionium dyes, quinonimine dyes, methine dyes, and the like. Phthalocyanine dyes are preferrred. Suitable dyes are salt-forming organic dyes and may be selected from oil-soluble dyes and basic dyes. Specific examples thereof are (herein is CI an abbreviation for Color Index): Oil Yellow 101, Oil Yellow 103, Oil Pink 312, Oil Green BG, Oil Bue GOS, Oil Blue 603, Oil Black BY, Oil Black BS, Oil Black T-505, Victoria Pure Blue, Crystal Violet (CI42555), Methyl Violet (CI42535), Ethyl Violet, Rhodamine B (CI415170B), Malachite Green (CI42000), Methylene Blue (CI52015). Also, the dyes dislosed in GB 2 192 729 may be used as colorant.

Typically, the amount of dye in the coating may be in the range of about 0.005 g/m² to 2 g/m², preferably about 0.007 g/m² to 0.5 g/m², more preferably about 0.01 g/m² to 0.2 g/m², most preferably about 0.01 g/m² to 0.1 g/m².

### Printing-out agent

The photopolymerizable layer or another layer of the coating may also comprise a printing-out agent, i.e. a compound which is capable of changing the color of the coating upon exposure. After image-wise exposing of the precursor, a visible image can be produced, hereinafter also referred to as "print-out image". The printing-out agent may be a compound as described in EP-A-1 491 356 paragraph [0116] to [0119] on page 19 and 20, and in US 2005/8971 paragraph [0168] to [0172] on page 17. Preferred printing-out agents are the compounds described in WO 2006/005688 from line 7 page 8 to line 32 page 20. More preferred are the IR-dyes as described in EP 1 736 312 from paragraph [0014] on page 3 to paragraph [0021] on page 29 and the IR-dyes described in WO 2006/136543.

### The contrast

The contrast of the image formed after image-wise exposure and processing with a gum solution is defined as the difference between the optical density in the exposed area to the optical density in the non-exposed area, and this contrast is preferably as high as possible. This enables the end-user to establish immediately whether or not the precursor has already been exposed and processed with a gum solution, to distinguish the different colour selections and to inspect the quality of the image on the treated plate precursor.

The contrast increases with increasing optical density in the exposed area and/or decreasing optical density in the non-exposed areas. The optical density in the exposed area may increase with the amount and extinction coefficient of the colorant remaining in the exposed areas, i.e. the pigment dispersion and dye of the coating of the precursor, and the intensity of colour formed by the printing-out agent. In the non-exposed areas it is preferred that the amount of colorant is as low as possible and that the intensity of colour print-out agent is as low as possible. The optical density can be measured in reflectance by an optical densitometer, equipped with several filters (e.g. cyan, magenta, yellow). The difference in optical density at the exposed area and the non-exposed area has preferably a value of at least 0.3, more preferably at least 0.4, most preferably at least 0.5. There is no specific upper limit for the contrast value, but typically the contrast is not higher than 3.0 or even not higher than 2.0. In order to obtain a good visual contrast for a human observer the type of colour of the colorant may also be important. Preferred colours for the colorant are cyan or blue colours, i.e. under blue colour we understand a colour that appears blue for the human eye.

### Surfactant

Various surfactants may be added into any of the coated layers of the precursor to allow or enhance the developability of the precursor when processing with a gum solution or with fountain solution and ink. Both polymeric and small molecule surfactants can be used. Nonionic surfactants are preferred. Preferred nonionic surfactants are polymers and oligomers containing one or more polyether (such as polyethylene glycol, polypropylene glycol, and copolymers of ethylene glycol and propylene glycol) segments. Examples of preferred nonionic surfactants are block copolymers of propylene glycol and ethylene glycol (also called block copolymers of propylene oxide and ethylene oxide); ethoxylated or propoxylated acrylate oligomers; and polyethoxylated alkylphenols and polyethoxylated fatty alcohols. The nonionic surfactant is preferably added in an amount ranging between 0.1 and 30% by weight of the coating, more preferably between 0.5 and 20%, and most preferably between 1 and 15%.

### Sensitizer

The photopolymerizable composition may also comprise a sensitizer which is an infrared light absorbing dye, having an absorption spectrum between 750 nm and 1300 nm, preferably between 780 nm and 1200 nm, more preferably between 800 nm and 1100 nm. Particular preferred sensitizers are heptamethinecyanine dyes, specially the dyes disclosed in EP 1 359 008 paragraph [0030] to [0032]. Other preferred sensitizers can be selected from the sensitizing dyes disclosed in US 6,410,205, US 5,049,479, EP 1 079 276, EP 1 369 232, EP 1 369 231, EP 1 341 040, US 2003/0124460, EP 1 241 002 and EP 1 288 720.

### The top layer

The coating may comprise a top layer which acts as an oxygen barrier layer, hereinafter also referred to as "overcoat layer" or "overcoat". Preferred binders which can be used in the top layer are polyvinyl alcohol and the polymers disclosed in WO 2005/029190, US 6,410,205 and EP 1 288 720, including the cited references in these patents and patent applications. The most preferred binder for the toplayer is polyvinylalcohol. The polyvinylalcohol has preferably an hydrolysis degree ranging between 74 mol % and 99 mol %. The weight average molecular weight of the polyvinylalcohol can be measured by the viscosity of an aqueous solution, 4 % by weight, at 20°C as defined in DIN 53 015, and this viscosity number ranges preferably between 3 and 26, more preferably between 3 and 15, most preferably between 3 and 10.

The coating thickness of the top layer is preferably between 0.25 and 2.0 g/m², more preferably between 0.25 and 1.5 g/m², most preferably between 0.6 and 1.25 g/m². In a more preferred embodiment of the present invention, the toplayer has a coating thickness between 0.25 and 1.75 g/m² and comprises a polyvinylalcohol having a hydrolysis degree ranging between 74 mol % and 99 mol % and a viscosity number as defined above ranging between 3 and 26.

In a preferred embodiment, the composition and the thickness of the toplayer are optimised in order to obtain a high sensitivity, a good daylight stability and less or no sludge formation during off-press processing with a gum solution. In order to reduce sludge, the toplayer may comprise less polyvinylalcohol and/or polyvinylalcohol with a lower molecular weight. Preferably a viscosity number of less than 26, more preferably less than 10 is used and a thickness as low as possible but more than 0.25 g/m². In order to improve the sensitivity, a good oxygen barrier is desired, using a polyvinylalcohol with a high hydrolysis degree, preferably 88-98%, and a greater thickness or the toplayer. In order to improve the daylight stability, a certain amount of penetration of oxygen is desired by using an oxygen barrier with a reduced barrier property for oxygen, preferably by using a smaller thickness of the toplayer and with polyvinylalcohol having a lower hydrolysis degree. Due to a good balance of these elements, an optimized property for the precursor can be obtained.

The top layer may also comprise a component selected from the compounds of the gum solution as described above.

### Exposure

The image-wise exposing step is carried out in a platesetter, i.e. an exposure apparatus suitable for image-wise exposing the precursor by a laser emitting IR-light. In a preferred embodiment of the present invention, the precursor is image-wise exposed by a laser diode, emitting around 830 nm, or a NdYAG laser, emitting around 1060 nm.

### Preheating

After this image-wise exposing step, the precursor is optionally heated to enhance or to speed-up the polymerization and/or crosslinking reaction. This preheat step is preferably carried out in a preheating unit at a temperature of 80°C to 150°C and during a dwell time of preferably 5 seconds to 1 minute. The preheating unit is preferably provided with heating elements such as IR-lamps, UV-lamps, heated air, a heated metal roll, etc. In a preferred embodiment of the present invention, no preheat step is performed.

### Processing

After the exposing step or, when a preheating step is present, after the preheating step, the precursor is processed with a gum solution or processed on-press with fountain solution and ink.

### The gum solution

A gum solution is typically an aqueous liquid which comprises one or more surface protective compounds that are capable of protecting the lithographic image of a printing plate against contamination, e.g. by oxidation, fingerprints, fats, oils or dust, or damaging, e.g. by scratches during handling of the plate. Suitable examples of such compounds are film-forming hydrophilic polymers or surfactants. The layer that remains on the plate after treatment with the gum solution preferably comprises between 0.005 and 20 g/m² of the surface protective compound, more preferably between 0.010 and 10 g/m², most preferably between 0.020 and 5 g/m².

In the present description, all concentrations of compounds present in the gum solution are expressed as percentage by weight (wt.% or % w/w) relative to the ready-to-use gum solution, unless otherwise indicated. A gum solution may be normally supplied as a concentrated solution which is diluted by the end user with water to a ready-to-use gum solution before use according to the instructions of the supplier, usually 1 part of the gum is diluted with 1 part to 10 parts of water.

Preferred polymers for use as protective compound in the gum solution are gum arabic, pullulan, cellulose derivatives such as carboxymethylcellulose, carboxyethylcellulose or methylcellulose, (cyclo)dextrin, poly(vinyl alcohol), poly(vinyl pyrrolidone), polysaccharide, homo- and copolymers of acrylic acid, methacrylic acid or acrylamide, a copolymer of vinyl methyl ether and maleic anhydride, a copolymer of vinyl acetate and maleic anhydride or a copolymer of styrene and maleic anhydride. Highly preferred polymers are homo- or copolymers of monomers containing carboxylic, sulfonic or phosphonic groups or the salts thereof, e.g. (meth)acrylic acid, vinyl acetate, styrene sulfonic acid, vinyl sulfonic acid, vinyl phosphonic acid or acrylamidopropane sulfonic acid.

Examples of surfactants for use as surface protective agent include anionic or nonionic surfactants. The gum solution may also comprise one or more of the above hydrophilic polymers as surface protective agent and, in addition, one or more surfactants to improve the surface properties of the coated layer. The surface tension of the gum solution is preferably from 20 to 50 mN/m.

The gum solution comprises preferably an anionic surfactant, more preferably an anionic surfactant whereof the anionic group is a sulphonic acid group.

Examples of the anionic surfactant include aliphates, abietates, hydroxyalkanesulfonates, alkanesulfonates, dialkylsulfosuccinates, straight-chain alkylbenzenesulfonates, branched alkylbenzenesulfonates, alkylnaphthalenesulfonates, alkylphenoxypolyoxyethylenepropylsulfonates, salts of polyoxyethylene alkylsulfophenyl ethers, sodium N-methyl-N-oleyltaurates, monoamide disodium N-alkylsulfosuccinates, petroleum sulfonates, sulfated castor oil, sulfated tallow oil, salts of sulfuric esters of aliphatic alkylesters, salts of alkylsulfuric esters, sulfuric esters of polyoxyethylenealkylethers, salts of sulfuric esters of aliphatic monoglycerides, salts of sulfuric esters of polyoxyethylenealkylphenylethers, salts of sulfuric esters of polyoxyethylenestyrylphenylethers, salts of alkylphosphoric esters, salts of phosphoric esters of polyox-yethylenealkylethers, salts of phosphoric esters of polyoxyethylenealkylphenylethers, partially saponified compounds of styrenemaleic anhydride copolymers, partially saponified compounds of olefin-maleic anhydride copolymers, and naphthalenesulfonateformalin condensates. Particularly preferred among these anionic surfactants are dialkylsulfosuccinates, salts of alkylsulfuric esters and alkylnaphthalenesulfonates.

Specific examples of suitable anionic surfactants include sodium dodecylphenoxybenzene disulfonate, the sodium salt of alkylated naphthalenesulfonate, disodium methylene-dinaphtalene-disulfonate, sodium dodecyl-benzenesulfonate, sulfonated alkyl-diphenyloxide, ammonium or potassium perfluoroalkylsulfonate and sodium dioctyl-sulfosuccinate.

Suitable examples of the nonionic surfactants include polyoxyethylene alkyl ethers, polyoxyethylene alkyl aryl ethers wherein the aryl group may be a phenyl group, a naphthyl group or an aromatic heterocyclic group, polyoxyethylene polystyryl phenyl ethers, polyoxyethylene polyoxypropylene alkyl ethers, polyoxyethylene polyoxypropylene block polymers, partial esters of glycerinaliphatic acids, partial esters of sorbitanaliphatic acid, partial esters of pentaerythritolaliphatic acid, propyleneglycolmonoaliphatic esters, partial esters of sucrosealiphatic acids, partial esters of polyoxyethylenesorbitanaliphatic acid, partial esters of polyoxyethylenesorbitolaliphatic acids, polyethyleneglycolaliphatic esters, partial esters of poly-glycerinaliphatic acids, polyoxyethylenated castor oils, partial esters of polyoxyethyleneglycerinaliphatic acids, aliphatic diethanolamides, N,N-bis-2-hydroxyalkylamines, polyoxyethylene alkylamines, triethanolaminealiphatic esters, and trialkylamine oxides. Particularly preferred among these nonionic surfactants are polyoxyethylene alkylphenyl ethers, polyoxyethylene alkylnaphthyl ethers and poloxyethylene-polyoxypropylene block polymers. Further, fluorinic and siliconic anionic and nonionic surfactants may be similarly used.

Two or more of the above surfactants may be used in combination. For example, a combination of two or more different anionic surfactants or a combination of an anionic surfactant and a nonionic surfactant may be preferred. The amount of such a surfactant is not specifically limited but is preferably from 0.01 to 30 wt.%, more preferably from 0.05 to 20 wt.%.

According to the present invention the gum solution has a pH-value preferably between 3 and 9, more preferably between 4.5 and 8.5, most preferably between 5 and 7. The pH of the gum solution is usually adjusted with a mineral acid, an organic acid or an inorganic salt in an amount of from 0.01 to 15 wt.%, preferably from 0.02 to 10 wt.%. Examples of the mineral acids include nitric acid, sulfuric acid, phosphoric acid and metaphosphoric acid. Especially organic acids are used as pH control agents and as desensitizing agents. Examples of the organic acids include carboxylic acids, sulfonic acids, phosphonic acids or salts thereof, e.g. succinates, phosphates, phosphonates, sulfates and sulfonates. Specific examples of the organic acid include citric acid, acetic acid, oxalic acid, malonic acid, p-toluenesulfonic acid, tartaric acid, malic acid, lactic acid, levulinic acid, phytic acid and organic phosphonic acid.

The gum solution further comprises preferably an inorganic salt. Examples of the inorganic salt include magnesium nitrate, monobasic sodium phosphate, dibasic sodium phosphate, nickel sulfate, sodium hexametaphosphate and sodium tripolyphosphate. An alkali-metal dihydrogen phosphate such as KH₂PO₄ or NaH₂PO₄ is most preferred. Other inorganic salts can be used as corrosion inhibiting agents, e.g. magnesium sulfate or zinc nitrate. The mineral acid, organic acid or inorganic salt may be used singly or in combination with one or more thereof.

In accordance with another embodiment of the present invention, the gum solution as developer in the processing of the plate comprises preferably a mixture of an anionic surfactant and an inorganic salt. In this mixture the anionic surfactant is preferably an anionic surfactant with a sulphonic acid group, more preferably an alkali-metal salt of a mono- or di-alkyl substituted diphenylether-sulphonic acid, and the inorganic salt is preferably a mono or dibasic phosphate salt, more preferably an alkali-metal dihydrogen phosphate, most preferably KH₂PO₄ or NaH₂PO₄.

The gum solution may also comprise a salt formed by reaction of an acid, selected from phosphoric acid and phosphorous acid, with a di- or tri-alkanolamine as disclosed in EP-A 07 108 228.3, filed on 15/05/2007.

In accordance with another embodiment of the present invention, the gum solution comprising a mixture of an anionic surfactant and an inorganic salt has preferably a pH-value between 3 and 9, more preferably between 4 and 8, most preferably between 5 and 7.

Besides the foregoing components, a wetting agent such as ethylene glycol, propylene glycol, triethylene glycol, butylene glycol, hexylene glycol, diethylene glycol, dipropylene glycol, glycerin, trimethylol propane and diglycerin may also be present in the gum solution. The wetting agent may be used singly or in combination with one or more thereof. In general, the foregoing wetting agent is preferably used in an amount of from 1 to 25 wt.%.

Further, a chelate compound may be present in the gum solution. Calcium ion and other impurities contained in the diluting water can have adverse effects on printing and thus cause the contamination of printed matter. This problem can be eliminated by adding a chelate compound to the diluting water. Preferred examples of such a chelate compound include organic phosphonic acids or phosphonoalkanetricarboxylic acids. Specific examples are potassium or sodium salts of ethylenediaminetetraacetic acid, diethylenetriaminepentaacetic acid, triethylenetetraminehexaacetic acid, hydroxyethylethylenediaminetriacetic acid, nitrilotriacetic acid, 1-hydroxyethane-1,1-diphosphonic acid and aminotri(methylenephosphonic acid). Besides these sodium or potassium salts of these chelating agents, organic amine salts are useful. The preferred amount of such a chelating agent to be added is from 0.001 to 5 wt.% relative to the gum solution in diluted form.

Further, an antiseptic and an anti-foaming agent may be present in the gum solution. Examples of such an antiseptic include phenol, derivatives thereof, formalin, imidazole derivatives, sodium dehydroacetate, 4-isothiazoline-3-one derivatives, benzoisothiazoline-3-one, benztriazole derivatives, amidineguanidine derivatives, quaternary ammonium salts, pyridine derivatives, quinoline derivatives, guanidine derivatives, diazine, triazole derivatives, oxazole and oxazine derivatives. The preferred amount of such an antiseptic to be added is such that it can exert a stable effect on bacteria, fungi, yeast or the like. Though depending on the kind of bacteria, fungi and yeast, it is preferably from 0.01 to 4 wt.% relative to the gum solution in diluted form. Further, preferably, two or more antiseptics may be used in combination to exert an aseptic effect on various fungi and bacteria. The anti-foaming agent is preferably silicone anti-foaming agents. Among these anti-foaming agents, either an emulsion dispersion type or solubilized type anti-foaming agent may be used. The proper amount of such an anti-foaming agent to be added is from 0.001 to 1.0 wt.% relative to the gum solution in diluted form.

In addition to the foregoing ingredients a radical stabilizing compound may be present in the gum. The proper amount of such radical stabilizing compound to be added is from 0.01 to 5 wt% relative to the gum solution in ready-to-used concentration. Typical radical stabilizers are disclosed in W02005/109103.

Besides the foregoing components, an ink receptivity agent may be present in the gum solution if desired. Examples of such an ink receptivity agent include turpentine oil, xylene, toluene, low heptane, solvent naphtha, kerosine, mineral spirit, hydrocarbons such as petroleum fraction having a boiling point of about 120°C to about 250°C, diester phthalates (e.g., dibutyl phthalate, diheptyl phthalate, di-n-octyl phthalate, di(2-ethylhexyl) phthalate, dinonyl phthalate, didecyl phthalate, dilauryl phthalate, butylbenzyl phthalate), aliphatic dibasic esters (e.g., dioctyl adipate, butylglycol adipate, dioctyl azelate, dibutyl sebacate, di(2-ethylhexyl) sebacate dioctyl sebacate), epoxidated triglycerides (e.g., epoxy soyabean oil), ester phosphates (e.g., tricresyl phosphate, trioctyl phosphate, trischloroethyl phosphate) and plasticizers having a solidification point of 15°C or less and a boiling point of 300°C or more at one atmospheric pressure such as esters of benzoates (e.g., benzyl benzoate). Examples of other solvents which can be used in combination with these solvents include ketones (e.g., cyclohexanone), halogenated hydrocarbons (e.g., ethylene dichloride), ethylene glycol ethers (e.g., ethylene glycol monomethyl ether, ethylene glycol monophenyl ether, ethylene glycol monobutyl ether), aliphatic acids (e.g., caproic acid, enathic acid, caprylic acid, pelargonic acid, capric acid, undecylic acid, lauric acid, tridecylic acid, myristic acid, pentadecylic acid, palmitic acid, heptadecylic acid, stearic acid, nonadecanic acid, arachic acid, behenic acid, lignoceric acid, cerotic acid, heptacosanoic acid, montanic acid, melissic acid, lacceric acid, isovaleric acid) and unsaturated aliphatic acids (e.g., acrylic acid, crotonic acid, isocrotonic acid, undecyclic acid, oleic acid, elaidic acid, cetoleic acid, erucic acid, butecidic acid, sorbic acid, linoleic acid, linolenic acid, arachidonic acid, propiolic acid, stearolic acid, clupanodonic acid, tariric acid, licanic acid). Preferably, it is an aliphatic acid which is liquid at a temperature of 50°C, more preferably has from 5 to 25 carbon atoms, most preferably has from 8 to 21 carbon atoms. The ink receptivity agent may be used singly or in combination with one or more thereof. The ink receptivity agent is preferably used in an amount of from 0.01 to 10 wt%, more preferably from 0.05 to 5 wt%. The foregoing ink receptivity agent may be present as an oil-in-water emulsion or may be solubilized with the aid of a solubilizing agent.

The viscosity of the gum solution can be adjusted to a value of e.g. between 1 and 5 mPa.s, by adding viscosity increasing compounds, such as poly(ethylene oxide) or polyvinylalcohol, e.g. having a molecular weight between 10⁴ and 10⁷. Such compounds can be present in a concentration of 0.01 to 10 g/l.

A baking gum has a similar composition as described above, with the additional preference towards compounds that do not evaporate at the usual bake temperatures. Baking gum solutions or baking gumming solutions can be aqueous solutions of sodium dodecyl phenoxy benzene disulphonate, alkylated naphthalene sulphonic acid, sulphonated alkyl diphenyl oxide, methylene dinaphtalene sulphonic acid, etc. Other gumming solutions contain a hydrophilic polymer component and an organic acid component. Still other baking gumming solutions contains the potassium salt of the hydroxyethylidene diphosphonic acid. Still other baking gumming solutions contain a sulphosuccinamate compound and phosphoric acid.

The contact angle between the baking gum solution and the plate is preferably lowered by adding at least one surfactant. Preferred surfactants are non-ionic polyglycols and perfluorated aliphatic polyester acrylates.

The viscosity of the baking gum solution is brought at a value of 1 to 5 mPa.s, more preferably 2 to 4.5 mPa.s by adding at least one viscosity increasing compound. Preferred viscosity increasing compounds are hydrophilic polymer compounds, more preferably polyethylene oxides. Said polyethylene oxides have preferably a molecular weight between 100,000 and 10,000,000, more preferably between 500,000 and 5,000,000. They are preferably used in a concentration of 0.01 to 10 g/l, more preferably of 0.05 to 5 g/l.

In another embodiment the baking gumming solutions comprises (a) water, (b) at least one hydrophilic polymer and (c) at least one component selected from the group consisting of water soluble organic acids comprising at least two acid functions and being selected form the group consisting of a benzene carboxylic acid, a benzene sulphonic acid, a benzene phosphonic acid, an alkane phosphonic acid and water soluble salts thereof. The mentioned compounds (b) and (c) which are dissolved in the aqueous solution in accordance with the present invention are such that they do not evaporate at the customary baking temperatures. The protective layer which is formed remains water-soluble, even after baking, and can be readily removed without damaging the printing plate.

Component (b) comprises in particular the following hydrophilic polymers : N-polyvinyl-pyrrolidone, polyvinylmethylether, copolymers containing ethylene units and maleic anhydride units, homopolymers or copolymers containing vinyl phosphonic acid units, vinyl methyl phosphinic acid units and/or acrylic acid units and/or a polyalkylene glycol, such as polyethylene glycol.

Component (c) comprises in particular : benzene disulphonic acids, benzene polycarboxylic acids having from 3 to 6 carboxyl groups, alkane diphosphonic acids which having from 1 to 3 carbon atoms in the alkane group, carboxyl group containing alkane diphosphonic acids which have from 5 to 9 carbon atoms in the alkane group, and/or one of the water-soluble salts of these acids (preferably alkali metal salts or ammonium salts). Specific examples of component (c) include benzene-1,3-disulphonic acid, benzene-1,2,4-tricarboxylic acid (trimellitic acid), benzene 1,2,4,5-tetracarboxylic acid (pyromellitic acid), benzene hexacarboxylic adid (mellitic acid), methane diphosphonic acid (diphosphono methane), 4,4-diphosphono-heptane-1,7-dioic acid (3,3-diphosphone-pimeic acid), and the sodium salts of these acids. In other embodiments the baking gumming solution for use can additionally contain hydroxy-polycarboxylic acids, such as citric acid and/or the salts thereof, water soluble alkanediols having at least 4 carbon atoms, such as hexanediol-(1,6) and surfactants (preferably anionic or non-ionic surfactants) such as alkyl aryl sulphonates, alkyl phenol ether sulphonates and a natural surfactant (e.g. Saponin). Specific examples of suitable baking gum solutions, ingredients and concentrations thereof, can be found in e.g. EP-A 222 297, EP-A 1 025 992, DE-A 2 626 473 and US 4,786,581.

### Gum-processing

In the gum-processing, the precursor is developed by applying a gum solution to the coating of the precursor, thereby removing the non-exposed areas of the photopolymerizable layer from the support to such an extent that no toning occurs during the printing process, and gumming the plate in a single step. This processing can be carried out in a gumming station which comprises at least one gumming unit wherein the gum is applied to the precursor by a spraying, jetting, dipping or coating technique or by rubbing in with an impregnated pad or by pouring-in, either by hand or in an automatic apparatus.

An example of a spray nozzle which can be used in the spraying technique, is an air assisted spray nozzle of the type SUJ1, commercially available at Spraying Systems Belgium, Brussels. The spray nozzle may be mounted on a distance of 50 mm to 200 mm between nozzle and receiving substrate. The flow rate of the spray solution may be set to 7 ml/min. During the spray process an air pressure in the range of 4.80x10⁵ Pa may be used on the spray head. This layer may be dried during the spraying process and/or after the spraying process. Typical examples of jet nozzles which can be used in the jetting technique, are ink-jet nozzles and valve-jet nozzles.

At least one of the gumming units may be provided with at least one roller for rubbing and/or brushing the coating while applying the gum to the coating. The gum used in the developing step can be collected in a tank and the gum can be used several times. The gum can be replenished by adding a replenishing solution to the tank of the gumming unit. In an alternative way, the gum solution may be used once-only, i.e. only starting gum solution is applied to the coating by preferably a spraying or jetting technique. Said starting gum solution is a gum solution which has not been used before for developing a precursor and has the same composition as the gum solution used at the start of the development.

Said replenishing solution is a solution which may be selected from a starting gum solution, a concentrated gum solution, a diluted gum solution, a solution of a non-ionic surfactant, water, a solution of a buffer having a pH ranging between 4 and 9, preferably between 5 and 7, or a baking gum. A concentrated or diluted gum solution is a solution comprising a higher respectively lower concentration of gum additives as defined above. A concentrated gum solution can be added as replenishing solution when the concentration of active products is under a desired level in the gum solution. A diluted gum solution or water can be used when the concentration of active products is above a desired level in the gum solution or when the viscosity of the gum solution is increased or when the volume of the gum solution is under a desired level, e.g. due to evaporation of the solvent or water. A solution of a non-ionic surfactant or a solution of a buffer can be added when the gum solution needs a higher concentration of a surfactant or when the pH of the gum solution needs to be controlled at a desired pH value or at a desired pH value in a range of two pH values, e.g. between 4 and 9, preferably between 5 and 7.

The addition of replenishing solution, i.e. the type and the amount of replenishing solution, may be regulated by the measurement of at least one of the following parameters such as the number and area of plate precursor developed, the time period of developing, the volume in each gumming unit (minimum and maximum level), the viscosity (or viscosity increase) of the gum solution, the pH (or pH change) of the gum solution, the density (or density increase) of the gum solution and the conductivity (or conductivity increase) of the gum solution, or a combination of at least two of them. The density (or density increase) of the gum solution can be measured with a PAAR densitometer.

The gum solution used in this step has preferably a temperature ranging between 15°C and 85°C, more preferably between 18°C and 65°C, most preferably between 20°C and 55°C.

In a preferred embodiment of the present invention, the gumming station comprises a first and a second gumming unit whereby the precursor is firstly developed in the first gumming unit and subsequently developed in the second gumming unit. The precursor may be firstly developed in the first gumming unit with gum solution which has been used in the second gumming unit, and, subsequently, developed in the second gumming unit with starting gum solution by preferably a spraying or jetting technique. In an alternative way, the first and second gumming unit preferably have the configuration of a cascade system, whereby the gum solution used for developing the precursor in the first and second gumming unit are respectively present in a first and a second tank, and whereby the gum solution of the second tank overflows to the first tank when replenishing solution is added in the second gumming unit. Optionally, also to the first gumming unit a replenishing solution can be added and this replenishing solution may be the same or another replenishing solution than added to the second gumming unit, e.g. a diluted gum solution, a solution of a non-ionic surfactant or water can be added as replenisher to the first gumming unit.

In another embodiment of the present invention, the gumming station comprises a first, a second and a third gumming unit whereby the precursor is firstly developed in the first gumming unit, subsequently in the second gumming unit and finally in the third gumming unit. The precursor may be firstly developed in the first gumming unit with gum solution which has been used in the second gumming unit, subsequently developed in the second gumming unit with gum solution which has been used in the third gumming unit, and finally developed in the third gumming unit with starting gum solution by preferably a spraying or jetting technique. In an alternative way, the first, second and third gumming unit preferably have the configuration of a cascade system, whereby the gum solution used for developing the precursor in the first, second and third gumming unit are respectively present in a first, a second and a third tank, and whereby the gum solution of the third tank overflows to the second tank when replenishing solution is added in the third gumming unit, and whereby the gum solution of the second tank overflows to the first tank. Optionally, also to the second and/or first gumming unit(s) a replenishing solution may be added and this replenishing solution may be the same or another replenishing solution than added to the third gumming unit, e.g. a diluted gum solution, a solution of a non-ionic surfactant or water can be added as replenisher to the second or first gumming unit. In another option, two different replenishing solutions can also be added to one gumming unit, e.g. a starting gum solution and water.

In another embodiment of the present invention, the gum solution used in each of the gumming units may be regenerated by removing of insoluble material present in the gum solution of a gumming unit. The presence of insoluble material in the gum solution may be caused by several reasons, e.g. by developing of a pigment containing coating, by evaporation of solvent or water of the gum solution, or by sedimentation, coagulation or flocculation of components in the gum solution. The insoluble material can be removed continueously or in batch form by several techniques such as filtration, ultrafiltration, centrifugation or decantation. A suitable apparatus for disposing a waste developing solution such as the gum solution of the present invention is described in EP-A 747 773. The apparatus can be connected to the tank of a gumming unit to regenerate the used gum solution by circulation of the gum solution over a filter or a filter membrane. The gum solution can be circulated over the filter or filter membrane continuously, periodically or during the development time, or the circulation is regulated by the measurement of the turbidity or transparency (i.e. optical transmission) of the gum solution whereby the circulation starts when the turbidity exceeds an upper value and stops when a under value is reached. The upper and under turbidity value can be chosen in relation to the desired degree of purification, generally the optical transmission of the gum solution is not lower than 50% of its value at starting, preferably not lower than 80%, more preferably not lower than 95%.

The plate can be dried after the gum-processing step in a drying unit. In a preferred embodiment the plate is dried by heating the plate in the drying unit which may contain at least one heating element selected from an IR-lamp, an UV-lamp, a heated metal roller or heated air. In a preferred embodiment of the present invention, the plate is dried with heated air as known in the drying section of a classical developing machine.

The plate can be heated in a baking unit, optionally after drying the plate. In a preferred embodiment of the present invention, when the plate is heated in a baking unit, the precursor is developed by using a baking gum and the gum solution is preferably replenished by adding a replenishing baking gum. Said replenishing baking gum is a solution which may be selected from a starting baking gum, i.e. a solution having the same composition as the baking gum used at the start of the development, a concentrated baking gum or a diluted baking gum, i.e. a solution having a higher respectively lower concentration of additives than the starting baking gum, and water.

The baking unit may contain at least one heating element selected from an IR-lamp, an UV-lamp, a heated metal roller or heated air. The plate is preferably heated in the baking unit at a temperature above 150°C and less than the decomposition temperature of the coating, more preferably between 200°C and 295°C, most preferably between 250°C and 290°C. A longer heating time is usually used when a lower heating temperature is used, and a shorter heating time is used when a higher heating temperature is used. The plate is preferably heated over a time period of less than 10 minutes, more preferably less than 5 minutes, most preferably less than 2 minutes.

The plate can be heated by the method as described in EP-A 1 506 854 or WO 2005/015318.

The drying step and the heating step may be combined in one single step wherein the plate, after the gum-developing step, is dried and heated in an integrated drying-baking station.

### On-press processing

In the on-press processing, the precursor is processed on-press, i.e. while the precursor is mounted on the plate cylinder of a lithographic printing press, the plate cylinder rotates while feeding dampening liquid and/or ink to the coating of the precursor. After a number of revolutions of the plate cylinder, preferably less than 50 revolutions, more preferably less than 10 revolutions, most preferably less than 5 revolutions, the non-exposed areas of the coating are removed from the support.

In a preferred embodiment, only dampening liquid is supplied to the plate during start-up of the press, and after a few revolutions the ink supply is switched on.

In an alternative embodiment, supply of dampening liquid and ink can be started simultaneously or only ink can be supplied during a number of revolutions before switching on the supply of dampening liquid.

In another alternative embodiment, a single fluid ink is supplied to the plate in this on-press processing. Single-fluid ink consists of an ink phase, also called the hydrophobic or oleophilic phase, and a polar phase which replaces the aqueous dampening liquid that is used in conventional wet offset printing. Suitable examples of single-fluid inks have been described in US 4,045,232; US 4,981,517 and US 6,140,392. In a most preferred embodiment, the single-fluid ink comprises an ink phase and a polyol phase as described in WO 00/32705.

### EXAMPLES

### Synthesis of 4-hydroxyphenyl-tribromomethyl-sulfone (PI-01) and of 4-methoxyphenyl-tribromomethyl-sulfone (PI-03)

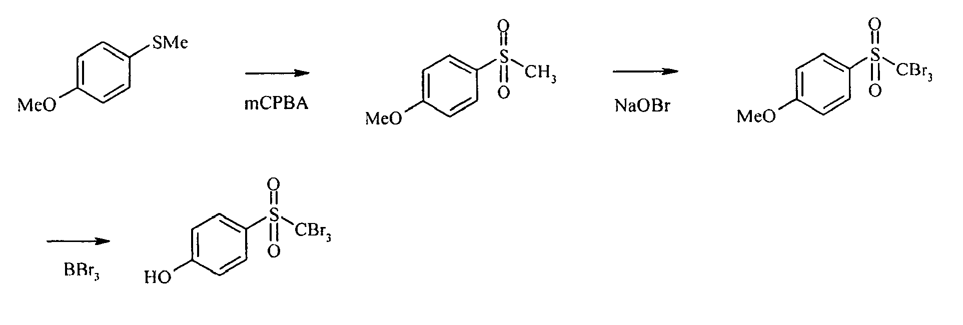

### 4-methoxyphenyl-methyl-sulfone

24 g (156 mmol) 4-methoxy-thioanisole was dissolved in 162 ml methylene chloride. 85 g (380 mmol) m.-chloro-perbenzoic acid (77%) was dissolved in 815 ml methylene chloride. The undissolved residue was removed and the m.-chloro-perbenzoic acid was added dropwise to the 4-methoxy-thioanisole solution. The reaction was allowed to continue for 90 minutes at room temperature. 9.9 g (81.1 mmol) thiodiglycol in 16 ml methylene chloride was added and the reaction was allowed to continue for an additional hour at room temperature. The precipitated m.-chloro-benzoic acid was removed by filtration and the mixture was extracted twice with 490 ml of a 10% NaHCO₃-solution and once with brine. The organic fraction was dried over MgSO₄ and evaporated under reduced pressure. The residue was treated twice with 65 ml tert.butyl-methyl-ether, isolated by filtration and dried. 26.79 g (92 %) of 4-methoxyphenyl-methyl-sulfone was isolated (m.p.: 108-23°C)

### 4-methoxyphenyl-tribromomethyl-sulfone (PI-03)

111.5 g potassium hydroxide was dissolved in 533 ml water. 372 ml 5 N NaOH was added followed by the addition of 40.5 ml (127.2 g, 0.8 mol) bromine. The temperature was kept below 45°C. The reaction was allowed to continue for 30 minutes at room temperature. 24.78 g (0.133 mol) 4-methoxyphenyl-methyl-sulfone was dissolved in 75 ml dioxane by gentle heating. The solution was added to the hypobromite solution and the reaction was allowed to continue for 48 hours at room temperature. 4-methoxyphenyl-tribromomethyl-sulfone was isolated by filtration, washed 5 times with 125 ml water and dried. 53.74 g (96 %) of 4-methoxyphenyl-tribromomethyl-sulfone was isolated (m.p.: 149-50°C).

### 4-hydroxyphenyl-tribromomethyl-sulfone (PI-01)

5.68 g (13.5 mmol) 4-methoxyphenyl-tribromomethyl-sulfone was dissolved in 100 ml 1 M borontribromide in methylene chloride. The reaction was allowed to continue at room temperature for 48 hours. The reaction mixture was carefully added to ice and the methylene chloride was removed from the mixture under reduced pressure. The precipitated crude 4-hydroxyphenyl-tribromomethyl-sulfone was isolated by filtration. The residue was treated with 200 ml methanol at reflux for 30 minutes. The methanol was evaporated under reduced pressure and the residue was treated with 2 1 0.2 N NaOH at room temperature for 1 hour. The undissolved residue was removed by filtration and the mixture was acidified with 2 N HCl (ca. 550 ml). 4-hydroxyphenyl-methyl-sulfone was allowed to crystallize over night, isolated by filtration, washed with water and dried. 4.58 g (83%) of 4-hydroxyphenyl-tribromomethyl-sulfone was isolated (m.p.: 199-200°C).

### Synthesis of 3-methoxyphenyl-tribromomethyl-sulfone (Comp-PI-04)

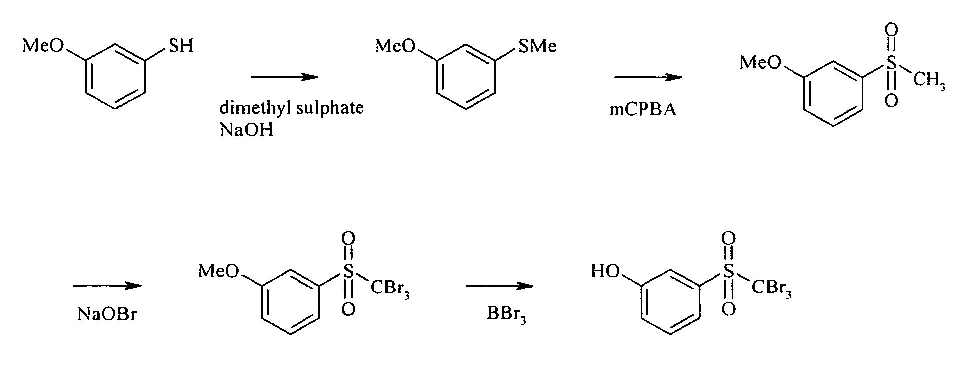

### 3-methoxy-thioanisole

10.0 g (71.3 mmol) 3-methoxy-thiophenole was dissolved in 43 ml water by adding 4.28 g (107 mmol) NaOH. 8.12 ml (10.79 g, 85.6 mmol) dimethyl sulfate was added dropwise. The reaction mixture was heated to reflux for 2 hours. The reaction mixture was allowed to coold down to room temperature and diluted with 70 ml water. The reaction mixture was extracted three times with 50 ml tert.butyl-methylether. The pooled organic fractions were extracted with 20 ml of a 10% NaOH solution and twice with 25 ml water. The organic fraction was dried over MgSO₄ and the solvent was removed under reduced pressure; 10.6 g (96 %) 3-methoxy-thioanisole was isolated.

### 3-methoxyphenyl-methyl-sulfone

37.5 g (167 mmol) m.-chloro-perbenzoic acid (77 %) was dissolved in 370 ml methylene chloride. The undissolved residue was removed and the solution was slowly added to a solution of 10.6 g (64.8 mmol) 3-methoxy-thionanisole in 70 ml methylene chloride. The reaction was allowed to continue for 90 minutes at room temperature. 3.7 ml (35.7 mmol) thiodiglycol in 7 ml methylene chloride was added and the reaction was allowed to continue for an additional hour at room temperature. The precipitated m.-chloro-benzoic acid was removed by filtration and the mixture was extracted three times with 220 ml of a 10 % NaHCO₃ solution and once with 250 ml brine. The organic fraction was dried over MgSO₄ and the solvent was evaporated under reduced pressure. 10.8 g (90 %) of 3-methoxyphenyl-methyl-sulfone was isolated as a yellow oil.

### 3-methoxyphenyl-tribromomethyl-sulfone (Comp-PI-04)

48.8 g (0.87 mol) potassium hydroxide was dissolved in 233 ml water. 163 ml 5 N NaOH was added, followed by the addition of 17.7 ml (55.6 g, 0.35 mol) bromine. The temperature was kept below 45°C. The reaction was allowed to continue for 30 minutes. A solution of 10.8 g (58.2 mmol) of 3-methoxyphenyl-methyl-sulfone in 33 ml dioxane was added and the reaction was allowed to continue for 48 hours at room temperature. The precipitated 3-mehoxyphenyl-tribromomethyl-sulfone was isolated by filtration, washed 5 times with 100 ml water and dried. The crude 3-methoxyphenyl-tribromomethyl-sulfone was dissolved in 100 ml chloroform. The undissolved residue was removed by filtration and the filtrate was dried over MgSO₄. The solvent was evaporated under reduced pressure and 20.5 g (83%) of 3-methoxyphenyl-tribromomethyl-sulfone was isolated (m.p.: 99-100°C).

### 3-hydroxyphenyl-tribromomethyl-sulfone

12 g (28.4 mmol) 3-methoxyphenyl-tribromomethyl sulfone was dissolved in 116 ml of a 1 M BBr₃-solution. The reaction was allowed to continue for 48 hours at room temperature. The reaction mixture was cooled to 0°C and 465 ml methanol was added while the temperature was kept at 0°C. The reaction was allowed to continue for an additional 10 minutes. The solvent was removed under reduced pressure and the residue was treated twice with 400 ml methanol, followed by evaporation under reduced pressure. 3-hydroxyphenyl-tribromomethyl-sulfone was purified by preparative column chromatography on Kieselgel 60, using cyclohexane-ethyl acetate 1/1 as eluent. 9.30 g (80 %) of 3-hydroxyphenyl-tribromomethyl-sulfone was isolated (m.p.: 147-8°C).

### Synthesis of 2-hydroxyphenyl-tribromomethyl-sulfone (PI-02) and of 2-methoxyphenyl-tribromomethyl-sulfone (PI-04)

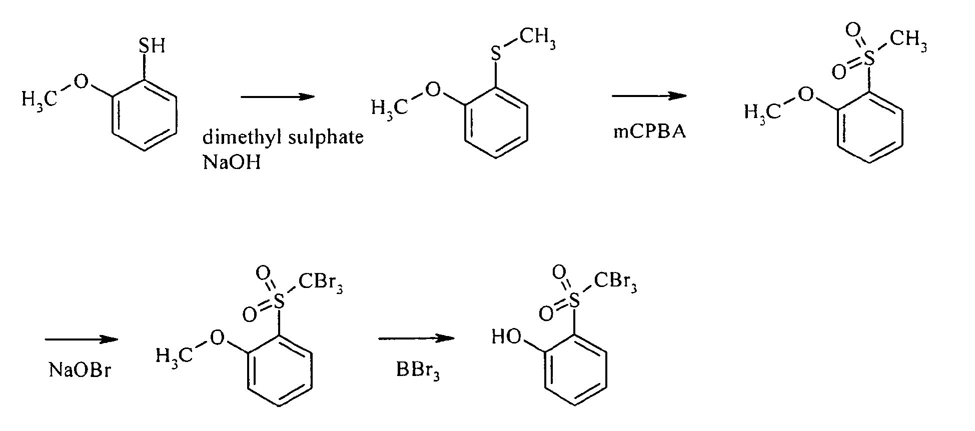

### 2-methylthio-anisole

10 g (71.3 mmol) 2-methoxy-thiophenole was dissolved in a solution of 4.28 g (107 mmol) NaOH in 43 ml water. 10.79 g (8.12 ml, 85.8 mmol) dimethyl sulphate was added dropwise. The mixture was refluxed for two hours. The mixture was allowed to cool down to room temperature and diluted with 70 ml water. The mixture was extracted three times with 70 ml tert.-butyl methyl ether. The pooled organic fractions were extracted with 20 ml of a 10% NaOH-solution and twice with 25 ml water. The organic fraction was dried over MgSO₄ and the solvent was evaporated under reduced pressure. 10.6 g (96 %) of 2-methylthio-anisole was isolated as a yellow liquid.

### 2-methoxyphenyl-methyl-sulfone

10.59 g (64.8 mmol) 2-methylthio-anisole was dissolved in 71 ml methylene chloride. A solution of 37.5 g (167. mmol) m-chloroperbenzoic acid (77%) in 370 ml methylene chloride was added while the temperature was kept between 20 and 25°C. The reaction was allowed to continue for one and a half hour at room temperature. 3.6 ml of thiodiglycol in 7 ml methylene chloride was added while the temperature was kept below 34°C. The reaction was allowed to continue for one hour at room temperature. The precipitated compounds were removed by filtration and the filtrate was extracted three times with 220 ml of 10% NaHCO₃-solution and once with 200 ml brine. The organic fraction was dried over MgSO₄. The solvent was removed under reduced pressure and 11.2 g (93 %) of 2-methoxyphenyl-methyl-sulfone was isolated (m.p.: 90-2°C).

### 2-methoxyphenyl-tribromomethyl-sufone (PI-04)

9.01 g (161 mmol) potassium hydroxide was dissolved in 43 ml water. 30 ml 5N NaOH was added, followed by the addition of 3.27 ml (10.3 g, 64.6 mmol) bromine. The mixture was stirred for 30 minutes. A solution of 2 g (10.75 mmol) 2-methoxyphenyl-methyl-sulfone in 6 ml dioxane was added and the reaction was allowed to continue for 48 hours at room temperature. 2-methoxyphenyl-tribromomethyl-sufone precipitated from the medium and was isolated by filtration, washed with water and dried. 4.52 g (99 %) of 2-methoxyphenyl-tribromomethyl-sufone was isolated (m.p.: 143-4°C).

### 2-hydroxyphenyl-tribromomethyl-sulfone (PI-02)

12 g (28.4 mmol) 2-methoxyphenyl-tribromomethyl-sulfone was added to 116 ml of a 1 M EBr₃-solution in methylene chloride. The reaction was allowed to continue for 48 hours at room temperature. The reaction mixture was cooled to 0°C and 500 ml methanol was added slowly. The mixture was stirred for 10 minutes at room temperature. The solvent was removed under reduced pressure. The residue was treated three times with 400 ml methanol and re-evaporated under reduced pressure. 2-hydroxyphenyl-tribromomethyl-sulfone was purified by preparative column chromatography on Kieselgel 60, using cyclohexane/ethyl acetate 5/1. 9.5 g (82 %) of 2-hydroxyphenyl-tribromomethyl-sulfone was isolated (m.p.: 87-8°C).

### Synthesis of 2,4-dimethoxyphenyl-tribromomethyl-sulfone (PI-05)

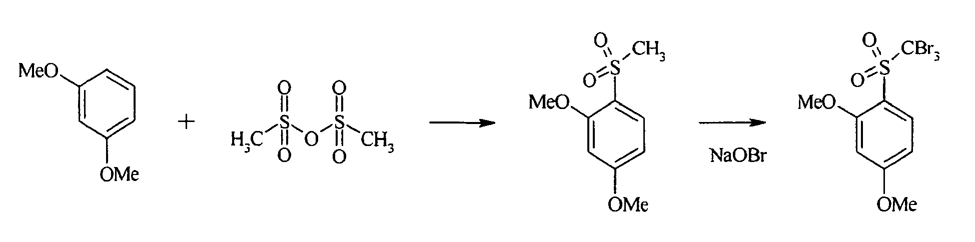

### 2,4-dimethoxyphenyl-methyl-sulfone

21.5 g (20.35 ml, 156 mmol) resorcinol dimethyl ether and 25 g (135 mmol) methane sulfonic anhydride (94%) were dissolved in 140 ml tetrachloro-ethylene and refluxed for 8 hours. The reaction mixture is allowed to cool down to room temperature and extracted twice with 70 ml hot water. The aqueous extracts were pooled, cooled to room temperature and extracted twice with 50 ml diethyl ether. An oily fraction separated from both the water and the ether fraction. The oily fraction, the ether fraction and the tetrachloro-ethylene fraction were pooled and the solvent was removed under reduced pressure. The residue was treated with a mixture of 75 ml cyclohexane and 25 ml ethyl acetate. 2,4-dimethoxyphenyl-methyl-sulfone was isolated by filtration, washed with a small fraction ethyl acetate and dried. 8.39 g (29 %) of 2,4-dimethoxyphenyl-methyl-sulfone was isolated (m.p.: 104-6°C).

### 2,4-dimethoxyphenyl-tribromomethyl-sulfone (PI-05)

33 g potassium hydroxide was dissolved in 156 ml water. 108 ml 5N NaOH was added followed by the addition of 11.85 ml(37.2 g, 233 mmol) bromine. The reaction was allowed to continue for 30 minutes at room temperature. A solution of 8.39 g (38.8 mmol) 2,4-dimethoxyphenyl-methyl-sulfone in 21 ml dioxane was added and the reaction was allowed to continue for 60 hours at room temperature. 2,4-dimethoxyphenyl-tribromomethyl-sulfone precipitated from the medium, was isolated by filtration, washed 5 times with 35 ml water and dried. The crude 2,4-dimethoxyphenyl-tribromomethyl-sulfone was recrystallized from toluene. 5.56 g (26 %) of 2,4-dimethoxyphenyl-tribromomethyl-sulfone was isolated (m.p.: 155-6°C).

### Synthesis of tribromomethyl-[4-(2-hydroxyethoxy)phenyl]sulfone (PI-07)

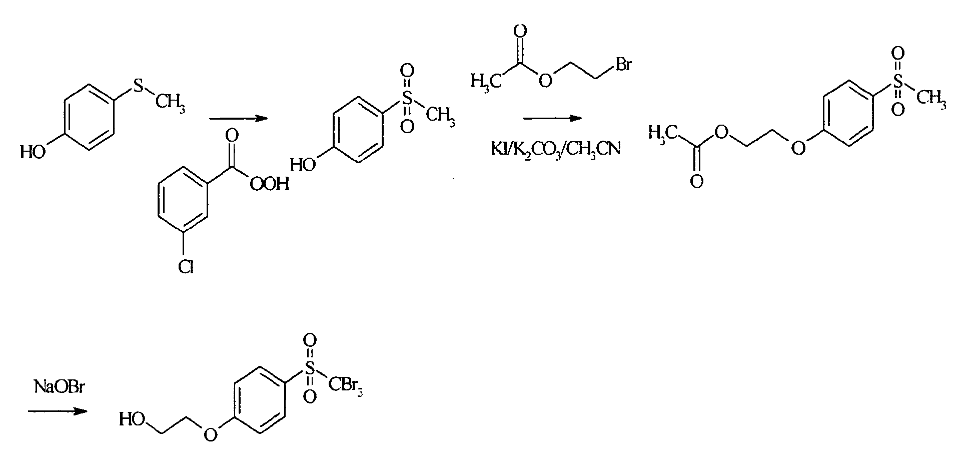

### 4-hydroxyphenyl-methyl-sulfone

58.3 g (260 mmol) 3-chloro-perbenzoic acid was dissolved in 558 ml methylene chloride. The undissolved residue was removed and the solution was added dropwise to solution of 15 g (107 mmol) 4-methylthio-phenol in 111 ml methylene chloride at 25°C. The reaction was allowed to continue for 90 minutes at room temperature. 5.56 ml (6.79 g, 55.6 mmol) thiodiglycol in 11 ml methylene chloride was added and the reaction was allowed to continue for 60 minutes at room temperature. 2N HCl was added and the precipitated 3-chlorobenzoic acid was removed by filtration. The aqueous fraction of the filtrate was extracted three times with methylene chloride. The pooled organic fractions were dried over MgSO₄ and evaporated under reduced pressure. 17.45 g (95 %) of 4-hydroxyphenyl-methyl-sulfone was isolated (m.p.: 92°C).

### 4-(2-acetoxyethoxy)phenyl-methyl-sulfone

3.90 g (22.6 mmol) 4-hydroxyphenyl-methyl-sulfone, 4.99 ml (7.57 g, 45.3 mmol) 2-bromoethylacetate, 200 mg potassium iodide and 7.8 g potassium carbonate were dissolved in 78 ml acetonitrile. The reaction was allowed to continue for 7 hours at reflux. The reaction mixture was allowed to cool down to room temperature. The inorganic salts were removed by filtration and the solvent was removed under reduced pressure. 6.25 g of 4-(2-acetoxyethoxy)phenyl-methyl-sulfone was isolated as an oil, which slowly crystallized (m.p.: 96-98°C).

### tribromomethyl-[4-(2-hydroxyethoxy)phenyl]sulfone (PI-07)

20.4 g potassium hydroxide was dissolved in 96 ml water. 70 ml 5N NaOH was added, followed by the addition of 23.2 g (145 mmol) bromine. The mixture was stirred for 30 minutes at room temperature. A suspension of 6.25 g of 4-(2-acetoxyethoxy)phenyl-methyl-sulfone in 17 ml dioxane was added at once. The reaction was allowed to continue for 20 hours at room temperature. The precipitated tribromomethyl-[4-(2-hydroxyethoxy)phenyl]sulfone was isolated by filtration, washed with water and dried; 3.91 g (36 %) of tribromomethyl-[4-(2-hydroxyethoxy)phenyl]sulfone was isolated (m.p.: 157-62°C)

### Synthesis of 4-(tribromomethanesulfonyl)-phenoxy-acetic acid (PI-08)

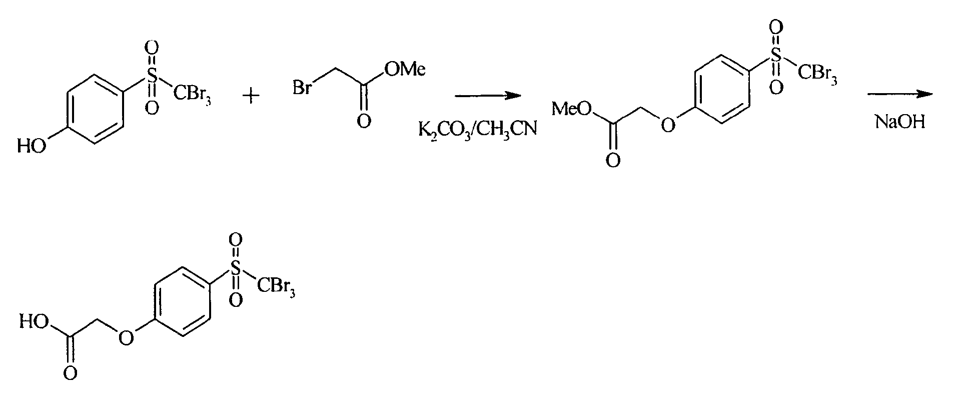

### 4-(tribromomethanesulfonyl)-phenoxy-acetic acid methyl ester

6.48 g (15.9 mmol) 4-hydroxyphenyl-tribromomethyl-sulfone, 6.57 g (48 mmol) potassium carbonate and 2.98 g (1.85 ml, 19.5 mmol) bromoacetic acid methyl ester were dissolved in 125 ml acetonitrile. The reaction was allowed to continue for 24 hours at room temperature. The precipitated salts were removed by filtration and the solvent was removed under reduced pressure. The crude 4-(tribromomethanesulfonyl)-phenoxy-acetic acid methyl ester was recrystallized from toluene. 5.28 g (67 %) of 4-(tribromomethanesulfonyl)-phenoxy-acetic acid methyl ester was isolated (m.p.: 152-3°C).

### 4-(tribromomethanesulfonyl)-phenoxy-acetic acid (PI-08)

5.28 g (10.7 mmol) 4-(tribromomethanesulfonyl)-phenoxy-acetic acid methyl ester was dissolved in 106 ml dioxane. 51 ml 0.25 N NaOH was added and the reaction was allowed to continue for 30 minutes at room temperature. The mixture was acidified using 2N HCl. The mixture was stirred for an additional 30 minutes at room temperature. The precipitated 4-(tribromomethanesulfonyl)-phenoxyacetic acid was isolated by filtration, washed with water and dried. 3.80 g (76 %) of 4-(tribromomethanesulfonyl)-phenoxy-acetic acid was isolated (m.p.: 238-46°C).

### Synthesis of 4-tolyl-tribromomethyl-sulfone (PI-06)

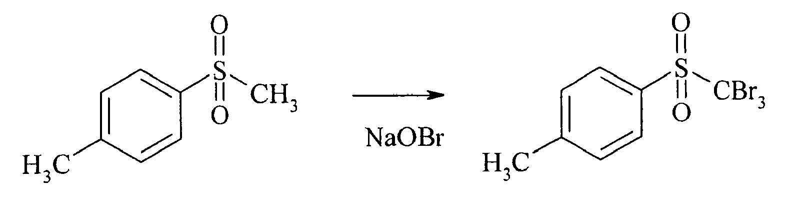

24.7 g (0.44 mol) potassium hydroxide was dissolved in 118 ml water. 82 ml 5 N NaOH was added followed by the addition of 9.0 ml (28.2 g, 0.18 mol) bromine. The reaction temperature was kept below 45°C. The reaction was allowed to continue for 30 minutes. A solution of 5 g (29 mmol) methyl-4-tolyl-sulfone in 16 ml dioxane was added and the reaction was allowed to continue for 48 hours at room temperature. 4-tolyl-tribromomethyl-sulfone was isolated by filtration,washed 5 times with 25 ml water and dried. 11.42g (97 %) of 4-tolyl-tribromomethyl-sulfone was isolated (m.p.: 153-4°C)

### Synthesis of 4-cyanophenyl-tribromomethyl-sulfone (Comp-PI-09)

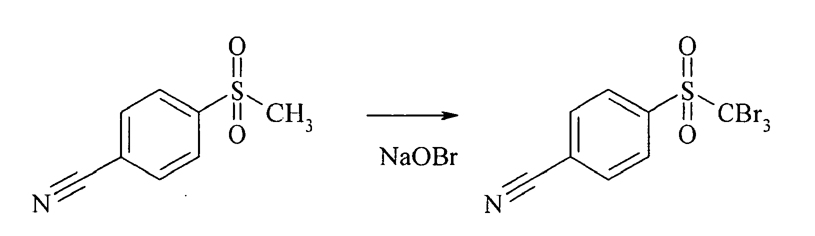

18.5 g (0.33 mol) potassium hydroxide was dissolved in 88 ml water. 60 ml 5N NaOH was added, followed by the addition of 6.7 ml (21.1 g, 0.13 mol) bromine. The reaction temperature was kept below 45°C. The reaction was allowed to continue for 30 minutes. 4.1 g (22.6 mmol) 4-cyanophenyl-methyl-sulfone was dissolved in 12 ml dioxane by gently heating and added to the hypobromite solution. The reaction was allowed to continue for 22 hours at room temperature. 4-cyanophenyl-tribromomethyl-sulfone was isolated by filtration, washed 5 times with 20 ml water and dried. The crude 4-cyanophenyl-tribromomethyl-sulfone was recrystallized from acetonitrile. 4.21 g (45 %) of 4-cyanophenyl-tribromomethyl-sulfone was isolated (m.p.: 231-4°C).

### Synthesis of 4-chlorophenyl-tribromomethyl-sulfone (Comp-PI-08)

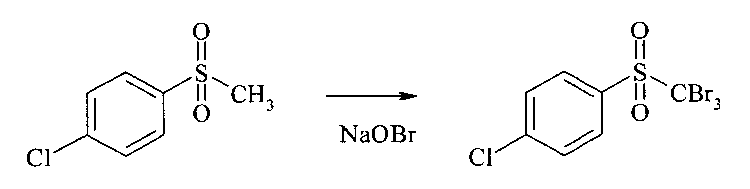

22g (0.392 mol) potassium hydroxide was dissolved in 105 ml water. 74 ml 5N NaOH was added, followed by the addition of 8 ml (25 g, 0.156 mol) bromine. The reaction temperature was kept below 40°C. The reaction was allowed to continue for 30 minutes. A solution of 4.8 g (25.2 mmol) 4-chlorophenyl-methyl-sulfone in 15 ml dioxane was added and the reaction was allowed to continue for 48 hours at room temperature. The crude 4-chlorophenyl-tribromomethyl-sulfone was isolated by filtration, dried and recrystallized from acetonitrile. 5.85 g (54 %) of 4-chlorophenyl-tribromomethyl-sulfone was isolated (m.p.: 168-70°C).

### Synthesis of 4-tribromomethanesulfonyl-benzoic acid derivatives

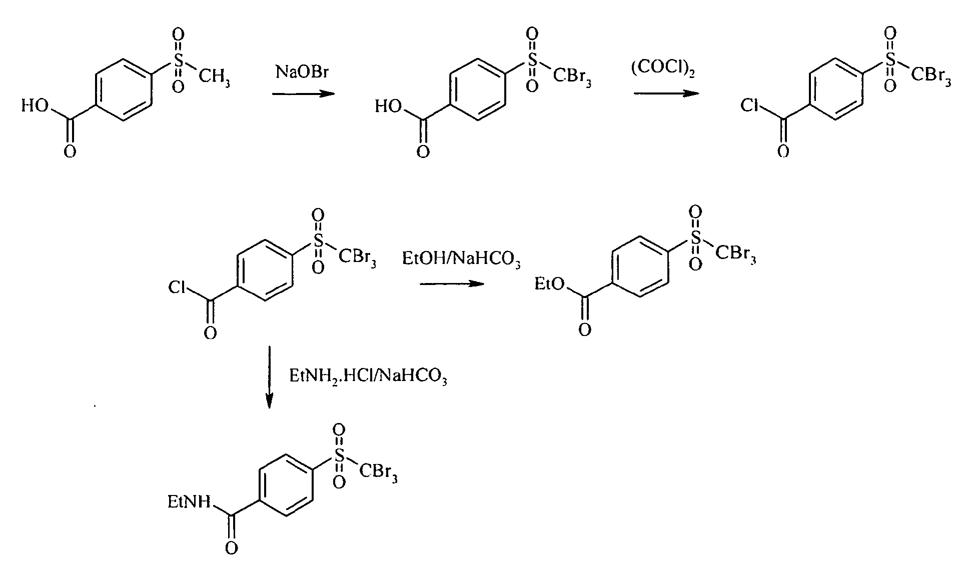

### 4-tribromomethanesulfonyl-benzoic acid

7.5 g (133.7 mmol) potassium hydroxide was dissolved in 35 ml water. 25 ml 5N NaOH was added, followed by the addition of 2.7 ml (8.42 g, 52.7 mmol) bromine. The mixture is stirred for an additional 30 minutes. 6 g sodium chloride was added to the mixture, followed by the addition of 2 g (10 mmol) 4-methanesulfonyl-benzoic acid. The reaction was allowed to continue for 3 hours at room temperature. The mixture was acidified with 2N HCl and the precipitated 4-tribromomethanesulfonyl-benzoic acid was isolated by filtration, washed with water and dried. 4.01 g (92 %) of 4-tribromomethanesulfonyl-benzoic acid was isolated (m.p.: > 305°C).

### 4-tribromomethanesulfonyl-benzoic acid ethyl ester (Comp-PI-06)

4.82 g (11 mmol) 4-tribromomethanesulfonyl-benzoic acid was suspended in 40 ml dioxane. A catalytic amount of DMF was added, followed by the addition of 1.36 ml (2.04 g, 16.1 mmol) oxalyl chloride. The reaction was allowed to continue for 2 hours at room temperature. The solvent was removed under reduced pressure and the residue was suspended in 120 ml ethanol. 4.8 g (57.1mmol) NaHCO₃ was added and the reaction was allowed to continue for one and a half hour at room temperature. 4-tribromomethanesulfonyl-benzoic acid ethyl ester was precipitated by the addition of water. 4-tribromomethanesulfonyl-benzoic acid ethyl ester was isolated by filtration and recrystallized from ethanol/water. 3.92 g (77 %) of 4-tribromomethanesulfonyl-benzoic acid ethyl ester was isolated (m.p.: 134-6°C).

### 4-tribromomethanesulfonyl-ethyl-benzamide (Comp-PI-07)

1.19 g (2.7 mmol) 4-tribromomethanesulfonyl-benzoic acid was suspended in 9 ml dioxane. A catalytic amount of DMF was added, followed by the addition of 0.5 ml (0.75 g, 5.9 mmol) oxalyl chloride. The reaction was allowed to continue for 2 hours at room temperature. The solvent was removed under reduced pressure and the residue was suspended in 9 ml dioxane. 2.2 g (26.2 mmol) NaHCO₃ and 0.7 g (8.6 mmol) ethylamine chlorohydrate were added and the reaction was allowed to continue for 4 hours at room temperature. 35 ml acetonitrile was added followed by slowly adding 30 ml water. The mixture was stirred for 10 minutes at room temperature. An additional 25 ml acetonitrile was added and the mixture was stirred for an additional 10 minutes. The mixture was diluted with 400 ml water and 4-tribromomethanesulfonyl-ethyl-benzamide precipitated from the medium. 4-tribromomethanesulfonyl-ethyl-benzamide was isolated by filtration, washed with water and dried. 0.92 g (73 %) of 4-tribromomethanesulfonyl-ethyl-benzamide was isolated (m.p.: 175-7°C).

### INVENTION EXAMPLE 1 and COMPARATIVE EXAMPLES 1 to 4

### Preparation of aluminum support S-1:

A 0.3 mm thick aluminium foil was degreased by spraying with an aqueous solution containing 26 g/l NaOH at 65°C for 2 seconds and rinsed with demineralised water for 1.5 seconds. The foil was then electrochemically grained during 10 seconds using an alternating current in an aqueous solution containing 15 g/l HCl, 15 g/l SO₄²⁻ ions and 5 g/l Al³⁺ ions at a temperature of 37°C and a current density of about 100 A/dm². Afterwards, the aluminium foil was then desmutted by etching with an aqueous solution containing 5.5 g/l of NaOH at 36°C for 2 seconds and rinsed with demineralised water for 2 seconds. The foil was subsequently subjected to anodic oxidation during 15 seconds in an aqueous solution containing 145 g/l of sulfuric acid at a temperature of 50°C and a current density of 17 A/dm², then washed with demineralised water for 11 seconds and dried at 120°C for 5 seconds.

The support thus obtained was characterised by a surface roughness Ra of 0.35-0.4 µm (measured with interferometer NT1100) and had an anodic weight of 3.0 g/m².

### Preparation of photosensitive layers P-1 to P-5

The coating compositions for the photosensitive layers P-1 to P-5 were prepared by mixing the ingredients as specified in Table 1. The resulting solutions were coated with a bar-coater at a wet thickness setting of 20 µm onto a support S-1. After coating, the layer was dried for 1 minute at 120°C in a circulation oven. The resulting total applied amount of material (in g/m²) is also indicated in Table 1.

**Table 1: Compositions of the photopolymerisable layer (amounts in g) and dry coating weight (in g/m²).**

| INGREDIENT (amount in g) | P-01 | P-02 | P-03 | P-04 | P-05 |
|---|---|---|---|---|---|
| Comp-PI-01 (1) (= Triazine) | 0.080 | - | - | - | - |
| Comp-PI-02 (2) (= HABI) | - | 0.177 | - | - | - |
| MBT (3) | - | 0.018 | - | - | - |
| Comp-PI-03 (4) (= TBMPS) | - | - | 0.177 | - | - |
| PI-01 (= p-OH-TBMPS) | - | - | - | 0.177 | 0.177 |
| Pig-disp-01 (5) | 0.798 | 0.798 | 0.798 | - | 0.798 |
| Comp-pig-disp (6) | - | - | - | 2.452 | - |
| Binder-01 (7) | 9.664 | 9.664 | - | 9.664 | - |
| Binder-02 (8) | - | - | 2.416 | - | 2.416 |
| IR-dye-01 (9) | 0.072 | 0.072 | 0.072 | 0.072 | 0.072 |
| FST 462R (10) | 0.810 | 0.810 | 0.810 | 0.810 | 0.810 |
| Edaplan LA411 (11) | 0.299 | 0.299 | 0.299 | 0.299 | 0.299 |
| Sipomer PAM100 (12) | 0.319 | 0.319 | 0.319 | 0.319 | 0.319 |
| Sokalan CP12S (13) | 0.480 | 0.480 | 0.480 | 0.480 | 0.480 |
| Ethanol | 21.422 | 21.422 | 27.713 | 20.01 | 21.422 |
| Dry coating weight (g/m²) | 1.137 | 1.196 | 1.186 | 1.186 | 1.186 |

| | | | | | |
|---|---|---|---|---|---|
| (1) Comp-PI-01 has the following structure 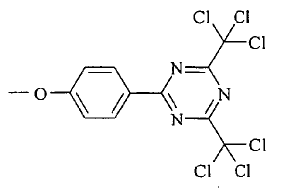 hereinafter also referred to as triazine. (2) Comp-PI-02 is 2-(2-chlorophenyl)-4,5-diphenyl bisimidazole, hereinafter also referred to as HABI, commercially available from SUMITOMO. (3) MBT is 2-mercaptobenzthiazole. (4) Comp-PI-03 is tribromomethyl-phenyl-sulphone, hereinafter also referred to as TBMPS; ∑(σ) = 0. (5) Pig-disp-01 is a dispersion of 15 wt% of Hostaperm Blue P-BFS and 15 wt% Disperbyk 182 in Dowanol PM. In this dispersion, Hostaperm Blue P-BFS, obtained from from Clariant, is stabilized with Disperbyk 182, obtained from BYK Chemie GmbH. Disperbyk 182 is a 43 wt% solution of a high molecular weight blockcopolymer with pigment affinic groups in a mixture of butylacetate, dipropyleneglycol monomethyl ether and 2-methoxy-1-methyl ethylacetate; Disperbyk 182 does not contain a -COOH, -PO₃H₂ or -OPO₃H₂ group. The dispersion is prepared in two steps: firstly, a pre-dispersion is prepared by adding 67.50 g of Hostaperm Blue P-BFS in small amounts to a solution of 156.94 g of Disperbyk 182 in 225.56 g of Dowanol PM while continuously stirring the mixture during 30 minutes at 400 rpm in a Disperlux stirrer. Subsequently, the resulting pre-dispersion is further milled during 30 minutes at 3000 rpm in a Netzch Mini-Zeta pearlmill, filled with 900 g of YTZ pearls with a diameter of 0.4 mm, obtained from TOSOH Europe B.V. The temperature is kept under 40°C during the milling process. This pigment dispersion has an average particle size of 123 nm (measured by Photon Correlation Spectroscopy according to ISO 13321). (6) Comp-pig-disp is Heliogene Blue D 7490 dispersion, trade name of BASF AG, a 9.77 wt% dispersion in 2-butanone of Heliogen Blue, stabilised with a methyl methacrylate/methacrylic acid-copolymer (ratio methylmethacrylate/methacrylic acid of 4:1 by weight; acid number: 110 mg KOH/g). (7) Binder-01 represents a 10 wt% solution in MEK of Gohsemfimer L-5407, a 36% hydrolyzed polyvinyl acetate commercially available from NIPPON GOHSEI. (8) Binder-02 represents a 40% by weight solution in water of Alcotex 552P, a polyvinyl acetate having a hydrolysis degree of 55 mol%, commercially available from Synthomer. (9) IR-dye-01 is an infrared absorbing dye having the following structure 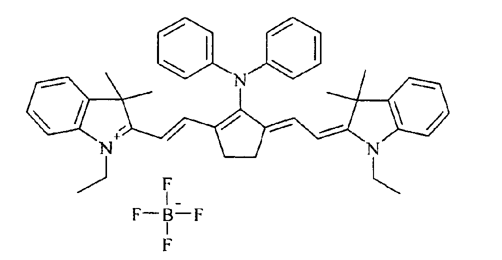 (10) FST 426R is a solution in 2-butanone (MEK) containing 89.8 % by weight of a reaction product from 1 mole of 2,2,4-trimethyl-hexamethylenediisocyanate and 2 moles of hydroxyethylmethacrylate (viscosity 3.30 mm²/s at 25°C). (11) Edaplan LA411 is a surfactant, obtained from Munzing Chemie and used here as a 1 wt% solution in Dowanol PM. Dowanol PM is propylene glycol monomethylether, trade mark of Dow Chemical Company. (12) Sipomer PAM100 is a 50 wt% solution in Dowanol PM of a phosphate functional speciality methacrylate monomer obtained from RHODIA. (13) Sokalan CP12S is a 5 wt% solution in water of a copolymer of acrylic acid and maleic acid, commercially available from BASF. | | | | | |

### Preparation of overcoat layer OC-1:

On top of the photosensitive layer, a solution in water with the composition as defined in Table 2 was coated (40 µm) and dried at 110°C for 2 minutes. The so-formed protective overcoat OC-1 has a dry thickness or dry coating weight of 1.60 g/m².

**Table 2: Composition of the overcoat solution.**

| COMPONENT | OC-1 |
|---|---|
| partially hydrolyzed polyvinylalcohol (degree of hydrolysis 88 %, viscosity 4 mPa·s in a solution of 4 wt.% at 20 °C) (g) | 17.03 |
| partially hydrolyzed polyvinylalcohol (degree of hydrolysis 88 %, viscosity 8 mPa·s in a solution of 4 wt.% at 20 °C) (g) | 7.43 |
| fully hydrolyzed polyvinylalcohol (degree of hydrolysis 98 %, viscosity 6 mPa·s in a solution of 4 wt.% at 20 °C) (g) | 14.87 |
| Acticide LA1206 (1) (g) | 0.26 |
| Metolat FC 355 (2) (g) | 0.38 |
| Lutensol A8 (90%) (3) (g) | 0.032 |
| Water (g) | 960 |

| | |
|---|---|
| (1) Acticide LA1206 is a biocide, commercially available from Thor. (2) Metolat FC 355 is an ethoxylated ethylenediamine, commercially available from Münzing Chemie. (3) Lutensol A8 (90% by weight) is a surface active agent, commercially available from BASF. | |

### Daylight-stability

The daylight stability of the printing plate precursors as prepared above without ageing was tested by exposing them to white light of 800 Lux (Philips Cool daylight TL-D 30W/54-765) for 4 hours whereby graduated neutral density filters were placed onto the plate precursors. Each of the 13 steps of the graduated filter as indicated in Table 3 below allows a certain percentage of the incident light to pass through.

The light passing through the filter may induce polymerization of the polymerisable layer. After the light exposure, the filter was removed from the precursor and, then, the exposed plates were processed in Gum-1 as described below. The number of steps which are not removed by processing, is a measure for the daylight stability, i.e. the less polymerized steps, the more daylight stable the plate precursor. The results are summarised in Table 4. In accordance with the present invention, the precursors are considered daylight stable when the number of steps in this test is less than 10.

**Table 3: Percentage of incident light passing through the graduated neutral density filter used (measured with a Skytronic Digital Lux meter).**

| FILTER | Percentage of incident light passing through the filter |
|---|---|
| Step 1 | 81 % |
| Step 2 | 76 % |
| Step 3 | 58% |
| Step 4 | 44% |
| Step 5 | 34% |
| Step 6 | 25% |
| Step 7 | 20% |
| Step 8 | 15% |
| Step 9 | 12% |
| Step 10 | 9% |
| Step 11 | 7% |
| Step 12 | 6% |
| Step 13 | 4% |

### Ageing

A part of each of these printing plate precursors was stored for 5 days in a cabinet conditioned at 34 % relative humidity and 50°C and these precursors are hereinafter also referred to as "aged" precursors.

Another part of each of these printing plate precursors was stored for the same time, i.e. 5 days, at ambient condition, i.e. at room temperature and without control of relative humidity, and these precursors are hereinafter also referred to as "fresh" precursors (i.e. precursors which are not aged).

### Imaging

On the "fresh" and "aged" printing plate precursors, 1x1 and 8x8 checkerboard patterns were imaged with a Creo Trendsetter 3244 equipped with a 40W IR-laser source (830 nm, 150 rpm, 200 lpi) at energy densities of resp. 40, 70, 100 and 130 mJ/cm².

### Processing

After imaging, both the fresh and aged printing plate precursors were subjected to processing with Gum-1 in a CRF45 processor (dwell time 30 s, at 21°C), available from Agfa Graphics, to remove the coating on the non-image areas from the support.

Gum-1 is a solution prepared as follow:
To 750 g demineralised water
   100 ml of Dowfax 3B2 (commercially available from Dow Chemical)
   31.25 g 1,3-benzene disulphonic acid disodium salt (available from Riedel de Haan)
   31.25 ml Versa TL77, a polystyrene sulphonic acid (available from Alco Chemical)
   10.4 g trisodium citrate dihydrate,
   2 ml of Acticide LA1206, a biocide (available from Thor) and
   2.08 g of Polyox WSRN-750 (available from Union Carbide)
   were added under stirring and
   demineralised water was further added to 1000 g.
   The pH is between 7.2 and 7.8.

### Printing

After processing, both the fresh and aged printing plates were printed on a Heidelberg GTO-46 printing press. Each print job was started using K+E Novavit 800 Skinnex ink (trademark of BASF Druckmachine GmbH)and FS404 (2 %) (trademark of Agfa Graphics) as fountain solution. A compressible blanket was used and printing was performed on non-coated offset paper. Each plate was printed up to 250 sheets.

### Clean-out performance and Toning

The clean-out performance is defined by completeness of removal of coating in the non-image areas from the support of the printing plate after processing. Toning is defined by the appearance of ink in the non-image areas, exhibiting background density on the printed sheets. When the coating in the non-exposed areas is insufficiently removed during processing or when the compounds remaining on the substrate are too hydrophobic, toning on the printed sheet results, i.e. the non-imaged areas are ink-accepting, exhibiting background density. The clean-out performance is evaluated on the press by evaluating whether or not the printed sheets show toning. When the printing plates exhibit too much toning, i.e. heavy toning, the background density on the printed sheets is too high and the sensitivity of the plate cannot be correctly determined.

### Sensitivity

The sensitivity of both the fresh and aged precursors was determined by measuring the dotsizes of the 1x1 and of the 8x8 checkerboard patterns on the 250th sheet at each energy density with a Gretag D19c densitometer (black filter setting). The dotsizes of the 1x1 and 8x8 checkerboards were plotted in a graph against the exposure energy densities. The (relative) sensitivity value was determined as the energy density at which the 1x1 and the 8x8 checkerboard lines on the graph intersect.
The results are summarised in Table 4. In accordance with the present invention, the precursors are considered to have a good shelf-life when the loss of sensitivity after ageing the precursor is less than 50 mJ/cm², preferably less than 45 mJ/cm², more preferably at most 40 mJ/cm².

Table 4: Results.

| Example (number) | Photo-Polymerrisable layer | Type photo-initiator | Daylight Stability (number of steps) | Toning upon ageing | Sensitivity loss upon ageing (mJ/cm²) |
|---|---|---|---|---|---|
| Comparative Example 1 | P-01 | Comp-PI-01 (Triazine) | 13 | No Toning | 27 |
| Comparative Example 2 | P-02 | Comp-PI-02 (Habi/MBT) | 20 | No Toning | 6 |
| Comparative Example 3 | P-03 | Comp-PI-03 (TBMPS) | 3 | No Toning | >52 |
| Comparative Example 4 | P-04 | PI-01 (p-OH-TBMPS) | 16 | Heavy Toning | nbd* |
| Inventive Example 1 | P-05 | PI-01 (p-OH-TBMPS) | 2 | No Toning | 0 |

| | | | | | |
|---|---|---|---|---|---|
| * cannot be determined | | | | | |

The Comparative Examples 1 and 2 demonstrate the lack of daylight stability of the precursors wherein another type of polymerization initator is used.

In Comparartive Example 3, it is demonstrated that, when the initiator tribromomethyl phenyl sulphone is not properly substituted by an electro-donating group, the precursor has a poor shelf-life resulting in a too high loss of sensitivity after ageing.

The Comparative Example 4 demonstrates that, in spite of the use of a polymerization initiator of the present invention, the precursor suffers from a lack of daylight stability resulting in heavy toning upon ageing, due to the fact that polymers comprising carboxylic acid groups are used as dispersants in the pigment dispersion.

The Invention Example 1 demonstrates the combined effect of good daylight stability and good shelf-life when the precursor comprises the combination of both a pigment dispersed with a dispersant of the present invention and a tribromomethyl-phenyl sulphone substituted in para with a hydroxyl group as polymerization initiator.

### INVENTION EXAMPLES 2 to 8 and COMPARATIVE EXAMPLES 5 to 10

The coating compositions for the photosensitive layers P-06 to P-18 were prepared by mixing the ingredients as specified in Tables 5 and 6. The resulting solutions were coated with a bar-coater at a wet thickness setting of 20 µm onto a support S-1. After coating, the layer was dried for 1 minute at 120°C in a circulation oven. The resulting total applied amount of material (in g/m²) is also indicated in Tables 5 and 6.

On top of the photosensitive layer, a solution in water with the composition as defined in Table 2 was coated (40 µm) and dried at 110°C for 2 minutes. The so-formed protective overcoat OC-1 has a dry thickness or dry coating weight of 1.60 g/m².

The printing plate precursors of the Invention Examples 2 to 8 and the Comparative Examples 5 to 10 are composed of the photosensitive layers P-06 to P-18 and the protective overcoat OC-1.

The printing plate precursors were imaged, processed and printed in the same way as described above for Invention Example 1. The results are summarised in Table 7.

**Table 5: Compositions of the photopolymerisable layer (amounts in g) and dry coating weight (in g/m²).**

| INGREDIENT (amount in g) | P-06 | P-07 | P-08 | P-09 | P-10 | P-11 |
|---|---|---|---|---|---|---|
| Comp-PI-03 (1) (= TBMPS) | 0.177 | - | - | - | - | - |
| PI-01 (= p-OH-TBMPS) | - | 0.177 | - | - | - | - |
| PI-03 (= p-OMe-TBMPS) | - | - | 0.177 | - | - | - |
| PI-04 (= o-OMe-TBMPS) | - | - | - | 0.177 | - | - |
| PI-05 (= o,p-di-OMe-TBMPS) | - | - | - | - | 0.177 | - |
| Comp-PI-04 (2) (= m-OMe-TBMPS) | - | | - | - | - | 0.177 |
| Pig-disp-01 (2) | 0.798 | 0.798 | 0.798 | 0.798 | 0.798 | 0.798 |
| Binder-01 (3) | 9.664 | 9.664 | 9.664 | 9.664 | 9.664 | 9.664 |
| IR-dye-01 (4) | 0.072 | 0.072 | 0.072 | 0.072 | 0.072 | 0.072 |
| FST 462R (5) | 0.810 | 0.810 | 0.810 | 0.810 | 0.810 | 0.810 |
| Edaplan LA411 (6) | 0.299 | 0.299 | 0.299 | 0.299 | 0.299 | 0.299 |
| Sipomer PAM100 (7) | 0.319 | 0.319 | 0.319 | 0.319 | 0.319 | 0.319 |
| Sokalan CP12S (8) | 0.480 | 0.480 | 0.480 | 0.480 | 0.480 | 0.480 |
| Ethanol | 21.422 | 21.422 | 21.422 | 21.422 | 21.422 | 21.422 |
| Dry coating weight (g/m²) | 1.186 | 1.186 | 1.186 | 1.186 | 1.186 | 1.186 |

| | | | | | | |
|---|---|---|---|---|---|---|
| (1) Comp-PI-03 is tribromomethyl-phenyl-sulphone; ∑(σ) = 0. (2) Comp-PI-04 is 3-methoxyphenyl-tribromomethyl-sulphone, hereinafter also referred to as m-OMe-TBMPS; ∑(σ) 0.12. (3) to (8): see Table 1. | | | | | | |

**Table 6: Compositions of the photopolymerisable layer (amounts in g) and dry coating weight (in g/m²).**

| INGREDIENT (amount in g) | P-12 | P-13 | P-14 | P-15 | P-16 | P-17 | P-18 |
|---|---|---|---|---|---|---|---|
| PI-06 (= p-Me-TBMPS) | 0.177 | - | - | - | - | - | - |
| PI-07 (= p-O-Et-OH-TBMPS) | - | 0.177 | - | - | - | - | - |
| PI-08 (= p-O-Me-COOH-TBMPS) | - | - | 0.177 | - | - | - | - |
| Comp-PI-06 (1) (= p-COO-Et-TBMPS) | - | - | - | 0.177 | - | - | - |
| Comp-PI-07 (2) (= p-CONH-Et-TBMPS) | - | - | - | - | 0.177 | | |
| Comp-PI-08 (3) (= p-Cl-TBMPS) | - | - | - | - | - | 0.177 | - |
| Comp-PI-09 (4) (= p-CN-TBMPS) | - | - | - | - | - | - | 0.177 |
| Pig-disp-01 (5) | 0.798 | 0.798 | 0.798 | 0.798 | 0.798 | 0.798 | 0.798 |
| Binder-01 (6) | 9.664 | 9.664 | 9.664 | 9.664 | 9.664 | 9.664 | 9.664 |
| IR-dye-01 (7) | 0.072 | 0.072 | 0.072 | 0.072 | 0.072 | 0.072 | 0.072 |
| FST 462R (8) | 0.810 | 0.810 | 0.810 | 0.810 | 0.810 | 0.810 | 0.810 |
| Edaplan LA411 (9) | 0.299 | 0.299 | 0.299 | 0.299 | 0.299 | 0.299 | 0.299 |
| Sipomer PAM100 (10) | 0.319 | 0.319 | 0.319 | 0.319 | 0.319 | 0.319 | 0.319 |
| Sokalan CP12S (11) | 0.480 | 0.480 | 0.480 | 0.480 | 0.480 | 0.480 | 0.480 |
| Ethanol | 21.422 | 21.422 | 21.422 | 21.422 | 21.422 | 21.422 | 21.422 |
| Dry coating weight (g/m²) | 1.186 | 1.186 | 1.186 | 1.186 | 1.186 | 1.186 | 1.186 |

| | | | | | | | |
|---|---|---|---|---|---|---|---|
| (1) Comp-PI-06 is 4-tribromomethanesulfonyl-benzoic acid ethyl ester, hereinafter also referred to as p-COO-Et-TBMPS; 2(a) = + 0.39. (2) Comp-PI-07 is 4-tribromomethanesulfonyl-ethyl-benzamide, hereinafter also referred to as p-CONH-Et-TBMPS; ∑(σ) = + 0.36. (3) Comp-PI-08 is 4-chlorophenyl-tribromomethyl-sulfone, hereinafter also referred to as p-Cl-TBMPS; Σ(σ) = + 0.23. (4) Comp-PI-09 is 4-cyanophenyl-tribromomethyl-sulfone, hereinafter also referred to as p-CN-TBMPS; Σ(σ) = + 0.66. (5) to (11) : see Table 1. | | | | | | | |

**Table 7: Results.**

| Example (number) | Photo-Polymerrisable layer | Type photoinitiator | Toning upon ageing | Sensitivity loss upon ageing (mJ/cm²) |
|---|---|---|---|---|
| Comparative Example 5 | P-06 | Comp-PI-03 (= TBMPS) | No Toning | 59 |
| Inventive Example 2 | P-07 | PI-01 (= p-OH-TBMPS) | No Toning | 10 |
| Inventive Example 3 | P-08 | PI-03 (= p-OMe-TBMPS) | No Toning | 46 |
| Inventive Example 4 | P-09 | PI-04 (= o-OMe-TBMPS) | No Toning | 34 |
| Inventive Example 5 | P-10 | PI-05 (=o,p-di-OMe-TBMPS) | No Toning | 17 |
| Comparative Example 6 | P-11 | Comp-PI-04 (= m-OMe-TBMPS) | No Toning | 57 |
| Inventive Example 6 | P-12 | PI-06 (= p-Me-TBMPS) | No Toning | 37 |
| Inventive Example 7 | P-13 | PI-07 (= p-O-Et-OH-TBMPS) | No Toning | 25 |
| Inventive Example 8 | P-14 | PI-08 (=p-OMe-COOH-TBMPS) | No Toning | 28 |
| Comparative Example 7 | P-15 | Comp-PI-06 (= p-COO-Et-TBMPS) | No Toning | 73 |
| Comparative Example 8 | P-16 | Comp-PI-07 (= p-CONH-Et-TBMPS) | No Toning | >50 |
| Comparative Example 9 | P-17 | Comp-PI-08 (= p-Cl-TBMPS) | No Toning | 80 |
| Comparative Example 10 | P-18 | Comp-PI-09 (= p-CN-TBMPS) | No Toning | 85 |

The number of steps in the daylight stability test as described above is less than 10 for the printing plate precursors of the Invention Examples 2 to 8 and the Comparative Examples 5 to 10. All these precursors, which comprise a substituted tribromomethyl phenyl sulphone and a pigment dispersed with a dispersant of the present invention, are daylight stable.

The Invention Examples 2 to 8 demonstrate the effect of daylight stability and good shelf-life when the precursors comprise the combination of both a pigment dispersed with a dispersant of the present invention and a tribromomethyl-phenyl sulphone substituted with an electron-donating group as defined in the present invention.

In Comparative Examples 5 to 10, it is demonstrated that, when the tribromomethyl phenyl sulphone initiator is not substituted by an electron-donating group, the precursor has a poor shelf-life resulting in a too high loss of sensitivity after ageing.

## Claims

1. A lithographic printing plate precursor comprising an aluminum support having a hydrophilic surface and a coating provided thereon, said coating comprises a photopolymerisable composition, comprising a polymerisable compound, a pigment dispersed with a dispersant, a polymerization initiator and a binder, **characterized in that** said dispersant is a compound free of - COOH, -PO₃H₂ or -OPO₃H₂ groups, and said polymerization initiator is a trihalomethyl-aryl sulphone, wherein the aryl group is substituted by at least one electron-donating group and wherein the sum of the Hammett constants (sigma) of the substituting groups on said aryl group has a negative value.

2. A lithographic printing plate precursor according to claim 1,
wherein said value of the sum of the Hammett constants (sigma) is less than -0.10.

3. A lithographic printing plate precursor according to any of the preceding claims, wherein said aryl group is a phenyl group.

4. A lithographic printing plate precursor according to claim 3, wherein said phenyl group is substituted by at least one electron-donating group in ortho or para position.

5. A lithographic printing plate precursor according to any of the preceding claims wherein the halo groups are bromo groups.

6. A lithographic printing plate precursor according to any of the preceding claims, wherein said electron-donating group is selected from a hydroxyl group, an alkoxy group, an alkyl group, an amino group, a mono-alkyl amino group, a mono-aryl amino group, a di-alkyl amino group, a di-aryl amino group, a tri-alkyl silane group, -NH(CO)R or -NH(CO)NHR wherein R is an alkyl or aryl group, or -O⁻M⁺ wherein M⁺ is an alkali metal ion, an ammonium ion or a tetra-alkyl ammonium ion.

7. A lithographic printing plate precursor according to any of the preceding claims, wherein said electron-donating group is selected from a hydroxyl group, an alkoxy group or an alkyl group.

8. A lithographic printing plate precursor according to any of the preceding claims, wherein said electron-donating group is a hydroxyl group.

9. A lithographic printing plate precursor according to any of the preceding claims, wherein said binder is a polymer or a mixture of polymers, with the proviso that, when the polymer comprises monomeric units having -COOH, -PO₃H₂ or -OPO₃H₂ groups, said polymer is present in the coating in an amount less than 0.1 g/m².

10. A lithographic printing plate precursor according to claim 9, wherein said polymer is selected from polyvinyl acetate, partially hydrolyzed polyvinyl acetate, polyethylene oxide, copolymers of ethylene oxide and/or propylene oxide, derivates of cellulose, gum Arabic, and copolymers containing at least one of the following monomeric units selected from vinyl acetate, vinyl alcohol, vinyl caprolactam, vinyl pyrrolidone, alkylated vinylpyrrolidone, alkyl (meth)acrylate, hydroxy-alkyl (meth)acrylate, (meth)acrylamide and monomeric units having a sulphonate group.

11. A lithographic printing plate precursor according to claim 10, wherein said polymer is polyvinylacetate hydrolyzed for less than 60 mol%.

12. A lithographic printing plate precursor according to claim 10, wherein said polymer is polyvinylacetate hydrolyzed for at least 15 mol% and for less than 60 mol%.

13. A method of making a lithographic printing plate comprising the steps of:
a) providing a lithographic printing plate precursor as defined in any of the preceding claims,
b) image-wise exposing said coating,
c) developing the precursor by treating the coating of the precursor with a gum solution thereby removing the coating from the support at the non-exposed areas.

14. A method of making a lithographic printing plate comprising the steps of:
a) providing a lithographic printing plate precursor as defined in any of the preceding claims 1 to 12,
b) image-wise exposing said coating,
c) developing the precursor by treating the coating of the precursor by mounting the exposed precursor on a plate cylinder of a lithographic printing press and rotating the plate cylinder while feeding dampening liquid and/or ink to the coating.

15. Use of a polymerization initiator being a trihalomethyl-aryl sulphone, wherein the aryl group is substituted by at least one electron- donating group and wherein the sum of the Hammett constants (sigma) of the substituting groups on said aryl group has a negative value, in the photopolymerisable composition of a lithographic printing plate precursor to improve the daylight stability and shelf-life of the precursor.

## Patentansprüche

1. Eine Vorstufe einer lithografischen Druckplatte, umfassend einen Aluminiumträger mit einer hydrophilen Oberfläche und eine darauf aufgetragene Beschichtung, wobei die Beschichtung eine fotopolymerisierbare Zusammensetzung, die eine polymerisierbare Verbindung, ein mittels eines Dispergiermittels dispergiertes Pigment, einen Polymerisationsinitiator und ein Bindemittel enthält, umfasst, **dadurch gekennzeichnet, dass** das Dispergiermittel eine Verbindung ohne -COOH-Gruppen, -PO₃H₂-Gruppen oder -OPO₃H₂-Gruppen ist und der Polymerisationsinitiator ein Trihalomethylarylsulfon ist, in dem die Arylgruppe durch mindestens eine Elektronendonorgruppe substituiert ist und die Summe der Hammett-Konstanten (Sigma) der substituierenden Gruppen auf der Arylgruppe einen negativen Wert hat.

2. Vorstufe einer lithografischen Druckplatte nach Anspruch 1, **dadurch gekennzeichnet, dass** der Wert der Summe der Hammett-Konstanten (Sigma) bei weniger als -0,10 liegt.

3. Vorstufe einer lithografischen Druckplatte nach einem der vorstehenden Ansprüche, **dadurch gekennzeichnet, dass** die Arylgruppe eine Phenylgruppe ist.

4. Vorstufe einer lithografischen Druckplatte nach Anspruch 3, **dadurch gekennzeichnet, dass** die Phenylgruppe durch mindestens eine Elektronendonorgruppe in ortho-Stellung oder para-Stellung substituiert ist.

5. Vorstufe einer lithografischen Druckplatte nach einem der vorstehenden Ansprüche, **dadurch gekennzeichnet, dass** die Halogruppen Bromgruppen sind.

6. Vorstufe einer lithografischen Druckplatte nach einem der vorstehenden Ansprüche, **dadurch gekennzeichnet, dass** die Elektronendonorgruppe aus der Gruppe bestehend aus einer Hydroxylgruppe, einer Alkoxygruppe, einer Alkylgruppe, einer Aminogruppe, einer Monoalkylaminogruppe, einer Monoarylaminogruppe, einer Dialkylaminogruppe, einer Diarylaminogruppe, einer Trialkylsilangruppe, einer -NH(CO)R-Gruppe oder einer -NH(CO)NHR-Gruppe, wobei R eine Alkylgruppe oder eine Arylgruppe bedeutet, oder -O⁻M⁺, wobei M⁺ ein Alkalimetallion, ein Ammoniumion oder ein Tetraalkylammoniumion bedeutet, gewählt wird.

7. Vorstufe einer lithografischen Druckplatte nach einem der vorstehenden Ansprüche, **dadurch gekennzeichnet, dass** die Elektronendonorgruppe aus der Gruppe bestehend aus einer Hydroxylgruppe, einer Alkoxygruppe und einer Alkylgruppe gewählt wird.

8. Vorstufe einer lithografischen Druckplatte nach einem der vorstehenden Ansprüche, **dadurch gekennzeichnet, dass** die Elektronendonorgruppe eine Hydroxylgruppe ist.

9. Vorstufe einer lithografischen Druckplatte nach einem der vorstehenden Ansprüche, **dadurch gekennzeichnet, dass** das Bindemittel ein Polymer oder Polymergemisch ist, mit der Maßgabe, dass, wenn das Polymer Monomereinheiten mit -COOH-, -PO₃H₂- oder -OPO₃H₂-Gruppen umfasst, das Polymer in einer Menge von weniger als 0,1 g/m² in der Beschichtung enthalten ist.

10. Vorstufe einer lithografischen Druckplatte nach Anspruch 9,
**dadurch gekennzeichnet, dass** das Polymer aus der Gruppe bestehend aus Polyvinylacetat, teilweise hydrolysiertem Polyvinylacetat, Polyethylenoxid, Copolymeren aus Ethylenoxid und/oder Propylenoxid, Cellulose-Derivaten, Gummiarabicum und Copolymeren, die mindestens eine der folgenden Monomereinheiten aus der Gruppe bestehend aus Vinylacetat, Vinylalkohol, Vinylcaprolactam, Vinylpyrrolidon, alkyliertem Vinylpyrrolidon, Alkyl(meth)acrylat, Hydroxyalkyl(meth)acrylat, (Meth)acrylamid und sulfonathaltigen Monomereinheiten enthalten, gewählt wird.

11. Vorstufe einer lithografischen Druckplatte nach Anspruch 10, **dadurch gekennzeichnet, dass** das Polymer zu weniger als 60 Mol-% hydrolysiertes Polyvinylacetat ist.

12. Vorstufe einer lithografischen Druckplatte nach Anspruch 10,
**dadurch gekennzeichnet, dass** das Polymer Polyvinylacetat ist, das um einen Wert zwischen mindestens 15 Mol-% und weniger als 60 Mol-% hydrolysiert ist.

13. Ein Verfahren zur Herstellung einer lithografischen Druckplatte,
umfassend die folgenden Schritte :
a) Bereitstellen einer wie nach einem der vorstehenden Ansprüche definierten Vorstufe einer lithografischen Druckplatte,
b) bildmäßige Belichtung der Beschichtung,
c) Entwicklung der Vorstufe durch Behandlung der Beschichtung der Vorstufe mit einer Gummierlösung, wobei die Beschichtung in den unbelichteten Bereichen vom Träger entfernt wird.

14. Ein Verfahren zur Herstellung einer lithografischen Druckplatte, umfassend die folgenden Schritte :
a) Bereitstellen einer wie nach einem der vorstehenden Ansprüche 1 bis 12 definierten Vorstufe einer lithografischen Druckplatte,
b) bildmäßige Belichtung der Beschichtung,
c) Entwicklung der Vorstufe durch Behandlung der Beschichtung der Vorstufe, wobei die belichtete Vorstufe auf einen Plattenzylinder einer lithografischen Druckmaschine aufgespannt wird und sich der Plattenzylinder sodann unter Benetzung der Beschichtung mit Feuchtwasser und/oder Einfärbung der Beschichtung mit Druckfarbe dreht.

15. Verwendung eines Polymerisationsinitiators, der ein Trihalomethylarylsulfon ist, in dem die Arylgruppe durch mindestens eine Elektronendonorgruppe substituiert ist und die Summe der Hammett-Konstanten (Sigma) der substituierenden Gruppen auf der Arylgruppe einen negativen Wert hat, in der fotopolymerisierbaren Zusammensetzung einer Vorstufe einer lithografischen Druckplatte, um die Tageslichtbeständigkeit und Lagerbeständigkeit der Vorstufe zu verbessern.

## Revendications

1. Un précurseur d'une plaque d'impression lithographique, comprenant un support d'aluminium ayant une surface hydrophile et un revêtement appliqué sur le support, ledit revêtement comprenant une composition photopolymérisable contenant un composé polymérisable, un pigment dispersé à l'aide d'un dispersant, un initiateur de polymérisation et un liant, **caractérisé en ce que** le dispersant est un composé qui ne comprend pas de groupes -COOH, -PO₃H₂ ou -OPO₃H₂ et que ledit initiateur de polymérisation est une sulfone de trihalométhylaryle dans laquelle le groupe aryle est substitué par au moins un groupe donneur d'électrons et la somme des constantes de Hammett (sigma) des groupes substituants sur le groupe aryle a une valeur négative.

2. Précurseur de plaque d'impression lithographique selon la revendication 1, **caractérisé en ce que** la valeur de la somme des constantes de Hammett (sigma) est inférieure à -0,10.

3. Précurseur de plaque d'impression lithographique selon l'une quelconque des revendications précédentes, **caractérisé en ce que** le groupe aryle est un groupe phényle.

4. Précurseur de plaque d'impression lithographique selon la revendication 3, **caractérisé en ce que** le groupe phényle est substitué par au moins un groupe donneur d'électrons en position ortho ou para.

5. Précurseur de plaque d'impression lithographique selon l'une quelconque des revendications précédentes, **caractérisé en ce que** les groupes halo sont des groupes bromo.

6. Précurseur de plaque d'impression lithographique selon l'une quelconque des revendications précédentes, **caractérisé en ce que** le groupe donneur d'électrons est choisi parmi le groupe composé d'un groupe hydroxyle, d'un groupe alkoxy, d'un groupe alkyle, d'un groupe amino, d'un groupe monoalkylamino, d'un groupe monoarylamino, d'un groupe dialkylamino, d'un groupe diarylamino, d'un groupe trialkylsilane, d'un groupe -NH(CO)R ou d'un groupe -NH(CO)NHR, où R est un groupe alkyle ou un groupe aryle, ou -O⁻ M⁺, où M⁺ est un ion de métal alcalin, un ion ammonium ou un ion tétraalkylammonium.

7. Précurseur de plaque d'impression lithographique selon l'une quelconque des revendications précédentes, **caractérisé en ce que** le groupe donneur d'électrons est choisi parmi le groupe composé d'un groupe hydroxyle, d'un groupe alkoxy et d'un groupe alkyle.

8. Précurseur de plaque d'impression lithographique selon l'une quelconque des revendications précédentes, **caractérisé en ce que** le groupe donneur d'électrons est un groupe hydroxyle.

9. Précurseur de plaque d'impression lithographique selon l'une quelconque des revendications précédentes, **caractérisé en ce que** le liant est un polymère ou un mélange de polymères, à condition que, dans le cas où le polymère comprend des unités monomères comprenant des groupes -COOH, -PO₃H₂ ou -OPO₃H₂, la quantité du polymère dans le revêtement soit inférieure à 0,1 g/m².

10. Précurseur de plaque d'impression lithographique selon la revendication 9, **caractérisé en ce que** le polymère est choisi parmi le groupe composé d'acétate de polyvinyle, d'acétate de polyvinyle partiellement hydrolysé, d'oxyde de polyéthylène, de copolymères d'oxyde d'éthylène et/ou d'oxyde de propylène, de dérivés de cellulose, de gomme arabique et de copolymères contenant au moins une des unités monomères suivantes choisies parmi le groupe composé d'acétate de vinyle, d'alcool vinylique, de caprolactame de vinyle, de vinylpyrrolidone, de vinylpyrrolidone alkylée, de (méth)acrylate d'alkyle, de (méth)acrylate d'hydroxyalkyle, de (méth)acrylamide et d'unités monomères comprenant un groupe sulfonate.

11. Précurseur de plaque d'impression lithographique selon la revendication 10, **caractérisé en ce que** le polymère est de l'acétate de polyvinyle hydrolysé à moins de 60 moles %.

12. Précurseur de plaque d'impression lithographique selon la revendication 10, **caractérisé en ce que** le polymère est de l'acétate de polyvinyle hydrolysé d'un degré compris entre au moins 15 moles % et moins de 60 moles %.

13. Un procédé pour la confection d'une plaque d'impression lithographique, comprenant les étapes ci-après :
a) la mise à disposition d'un précurseur de plaque d'impression lithographique tel que défini selon l'une quelconque des revendications précédentes,
b) l'exposition sous forme d'image du revêtement,
c) le développement du précurseur en traitant le revêtement du précurseur avec une solution de gommage, permettant d'éliminer ainsi le revêtement du support dans les zones non exposées.

14. Un procédé pour la confection d'une plaque d'impression lithographique, comprenant les étapes ci-après :
a) la mise à disposition d'un précurseur de plaque d'impression lithographique tel que défini selon l'une quelconque des revendications précédentes 1 à 12,
b) l'exposition sous forme d'image du revêtement,
c) le développement du précurseur en traitant le revêtement du précurseur de façon à serrer le précurseur exposé sur un cylindre porte-plaque d'une machine d'impression lithographique et à faire tourner le cylindre porte-plaque pendant que le revêtement est mouillé d'une solution de mouillage et/ou encré d'une encre d'imprimerie.

15. Utilisation d'un initiateur de polymérisation qui est une sulfone de trihalométhylaryle, où le groupe aryle est substitué par au moins un groupe donneur d'électrons et la somme des constantes de Hammett (sigma) des groupes substituants sur le groupe aryle a une valeur négative, dans la composition photopolymérisable d'un précurseur de plaque d'impression lithographique, afin d'améliorer la résistance à la lumière du jour et la stabilité au stockage du précurseur.
